# EUROPÄISCHE PATENTSCHRIFT

(11) **EP 2 297 800 B1**
(45) Veröffentlichungstag und Bekanntmachung des Hinweises auf die Patenterteilung: **14.08.2019**
(21) Anmeldenummer: 09761714.6
(22) Anmeldetag: 09.06.2009
(51) Int. Cl.: H01L 51/54, C07F 15/00, C09K 11/06

(54) **DEUTERIERTE ÜBERGANGSMETALL- KOMPLEXE UND DEREN VERWENDUNG IN ORGANISCHEN LEUCHTDIODEN**
DEUTERATED TRANSITION METAL COMPLEX AND USE THEREOF IN ORGANIC LIGHT-EMITTING DIODES
COMPLEXES DE MÉTAUX DE TRANSITION DEUTÉRIÉS ET LEUR UTILISATION DANS DES DIODES ÉLECTROLUMINESCENTES ORGANIQUES

(30) Priorität: 10.06.2008 EP 08157913
(43) Veröffentlichungstag der Anmeldung: 23.03.2011
(73) Patentinhaber: UDC Ireland Limited, Ballycoolin, Dublin 15 (IE)
(72) Erfinder: MOLT, Oliver, 69493 Hirschberg (DE); LENNARTZ, Christian, 67105 Schifferstadt (DE); FUCHS, Evelyn, 68199 Mannheim (DE); DORMANN, Korinna, 67098 Bad Dürkheim (DE); LANGER, Nicolle, 64646 Heppenheim (DE); SCHILDKNECHT, Christian, 68305 Mannheim (DE); RUDOLPH, Jens, 67547 Worms (DE); WAGENBLAST, Gerhard, 67157 Wachenheim (DE); WATANABE, Soichi, 68161 Mannheim (DE)
(74) Vertreter: Maiwald Patent- und Rechtsanwaltsgesellschaft mbH
(86) Internationale Anmeldenummer: PCT/EP2009/057089
(87) Internationale Veröffentlichungsnummer: WO 2009/150151

(56) Entgegenhaltungen:
- WO-A-02/47440
- WO-A-2006/096951
- WO-A-2007/095118
- WO-A-2008/156879
- WO-A1-2006/095951

## Beschreibung

Die vorliegende Erfindung betrifft Metallkomplexe enthaltend mindestens einen polycyclischen aromatischen Liganden, wobei die Metallkomplexe mindestens ein Deuteriumatom tragen, eine organische Leuchtdiode enthaltend mindestens einen erfindungsgemäßen Metallkomplex, eine Licht-emittierende Schicht enthaltend mindestens einen erfindungsgemäßen Metallkomplex, eine organische Leuchtdiode enthaltend mindestens eine erfindungsgemäße Licht-emittierende Schicht, die Verwendung des mindestens einen erfindungsgemäßen Metallkomplexes in organischen Leuchtdioden sowie eine Vorrichtung ausgewählt aus der Gruppe bestehend aus stationären Bildschirmen, wie Bildschirmen von Computern, Fernsehern, Bildschirmen in Druckern, Küchengeräten sowie Reklametafeln, Beleuchtungen, Hinweistafeln und mobilen Bildschirmen, wie Bildschirmen in Handys, Laptops, Digitalkameras, Fahrzeugen sowie Zielanzeigen an Bussen und Bahnen, enthaltend mindestens eine erfindungsgemäße organische Leuchtdiode.

In organischen Leuchtdioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigen Stromverbrauchs eignen sich die Vorrichtungen enthaltend OLEDs insbesondere für mobile Anwendungen, z. B. für Anwendungen in Handys, Laptops, usw.

Die Grundprinzipien der Funktionsweise von OLEDs sowie geeignete Aufbauten (Schichten) von OLEDs sind z. B. in WO 2005/113704 und deren zitierten Literatur genannt.

Als Licht-emittierende Materialien (Emitter) können neben fluoreszierenden Materialien (Fluoreszenz-Emitter) phosphoreszierende Materialien (Phosphoreszenz-Emitter) eingesetzt werden. Bei den Phosphoreszenz-Emittern handelt es sich üblicherweise um metallorganische Komplexe, die im Gegensatz zu den Fluoreszenz-Emittern, die eine Singulett-Emission zeigen, eine Triplett-Emission zeigen (M. A. Baldo et al., Appl. Phys. Lett. 1999, 75, 4 - 6). Aus quantenmechanischen Gründen ist bei Verwendung der Phosphoreszenz-Emitter eine bis zu vierfache Quanten-, Energie- und Leistungseffizienz möglich. Um die Vorteile des Einbaus der metallorganischen Phosphoreszenz-Emitter in die Praxis umzusetzen, ist es erforderlich, Phosphoreszenz-Emitter bereitzustellen, die eine hohe operative Lebensdauer, eine hohe Effizienz, eine hohe Stabilität gegenüber Temperaturbelastung und eine niedrige Einsatz- und Betriebsspannung aufweisen.

Um den vorstehend genannten Anforderungen zu genügen, sind zahlreiche Phosphoreszenz-Emitter im Stand der Technik vorgeschlagen worden.

So betrifft WO 2007/095118 Metallkomplexe cyclometallierter Imidazo[1,2-f]phenanthridin- und Diimidazo[1,2-A:1',2'-C]chinazolinliganden sowie isoelektronischer und benzanellierter Derivate davon. Die Metallkomplexe sind phosphoreszierend und werden in OLEDs eingesetzt. Die OLEDs zeigen gemäß WO 2007/095118 eine langlebige und effiziente blaue, grüne und rote Emission. Deuterierte Systeme sind in WO 2007/095118 nicht erwähnt.

WO 2008/156879 beschreibt phosphoreszierende Metallkomplexe cyclometallierter Imidazo[1,2-f]phenanthridine, sowie isoelektronischer und benzanellierter Derivate davon. OLEDs mit diesen Verbindungen werden auch beschrieben.

In WO 2007/093282 ist ein spezielles elektronisches Bauteil sowie ein Verfahren zu dessen Herstellung und dessen Verwendung erwähnt. Bei diesem elektronischen Bauteil kann es sich z. B. um eine OLED handeln. Gemäß der Beschreibung in WO 2007/093282 enthält das elektronische Bauteil chemisch reaktive Materialien, wobei es sich um Elektrolumineszenz- bzw. Lasermaterialien handelt. Unter anderem sind als reaktive Materialien metallorganische Komplexe genannt, die zur Phosphoreszenz befähigt sind (J). Bei diesen metallorganischen Komplexen handelt es sich u. a. um metallorganische Komplexe der Formel (T) [M(L)ₙ(L')ₘ(L")ₒ], die eine Teilstruktur M(L)ₙ gemäß Formel (U) aufweisen können

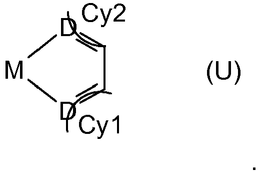

Die Zyklen Cy1 und Cy2 können mit Resten R substituiert sein, wobei es sich bei R u. a. um Deuterium handeln kann. Beispiele für Verbindungen der Formel (T), die Struktureinheiten der Formel (U) enthalten, sind in WO 2007/093282 nicht erwähnt. Des Weiteren ergibt sich aus WO 2007/093282 nicht, ob Metallkomplexe der Formel (T), die Struktureinheiten der Formel (U) enthalten, wobei einer der Zyklen Cy1 bzw. Cy2 mit Deuterium substituiert ist, für den Einsatz in OLEDs vorteilhaft sind.

EP-A 1 372 360 betrifft organische elektrolumineszente Polymere mit verbesserter Stabilität. Als Polymere werden Poly(phenylenvinylene) eingesetzt. Um die Stabilität der Vinylbindungen in den Poly(phenylenvinylenen) entlang der konjugierten Polymerkette weiter zu verbessern, werden gemäß EP-A 1 372 360 Poly(phenylenvinylene) eingesetzt, die eine Deuterium-Substitution am Vinylenteil aufweisen. Der Grund für den Einsatz deuterierter Polymere ist gemäß EP-A 1 372 360 somit die Stabilisierung der reaktiven Vinylen-Doppelbindungen der Poly(phenylenvinylene).

In WO 02/47440 A1 sind organische Halbleitermaterialien offenbart, worin ein oder mehrere Wasserstoffatome durch Deuterium ersetzt sind. Die organischen Halbleiter weisen eine hohe Lumineszenz und eine gute thermische Stabilität auf. Es wird behauptet, dass optoelektronische Elemente, die die organischen Halbleiter enthalten, eine verbesserte Performance und Lebensdauer aufweisen. Bevorzugt handelt es sich bei den organischen Halbleitern um lumineszierende organische Polymere oder metallorganische Verbindungen. In der Beschreibung ist eine große Zahl verschiedener organischer Halbleitermaterialien genannt. In den Beispielen in WO 02/47440 A1 ist erwähnt, dass eine organische Leuchtdiode, die vollständig deuteriertes Ir(ppy)₃-d8 als Emittermaterial aufweist, eine höhere Quanteneffizienz und Leuchtstärke aufweist als eine organische Leuchtdiode, die nicht deuteriertes Ir(ppy)₃ als Emittermaterial enthält.

Die in WO 02/47440 A1 offenbarten Ergebnisse entsprechen den in WO 2006/095951 A1 offenbarten Ergebnissen. In WO 2006/095951 A1 sind deuterierte phosphoreszierende Ir-Komplexe 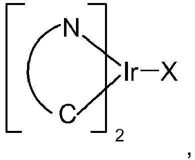 worin X ein bidentater Ligand ist, und deren Einsatz als Emittermaterial in OLEDs offenbart. OLEDs, die diese deuterierten Komplexe als Emittermaterial enthalten, weisen gemäß WO 2006/095951 A1 eine höhere Quanteneffizienz und Leuchtstärke auf als OLEDs, die die entsprechenden nicht deuterierten Ir-Komplexe als Emittermaterial enthalten.

Aufgabe der vorliegenden Erfindung gegenüber dem vorstehend genannten Stand der Technik ist es, weitere zur Phosphoreszenz geeignete Metallkomplexe für die Verwendung in OLEDs bereitzustellen, die ein ausgewogenes Eigenschaftsspektrum zeigen, z. B. gute Effizienzen, eine verbesserte Lebensdauer und höhere Stabilitäten im Device sowie gute Ladungstransporteigenschaften und thermische Stabilität. Dabei sollen insbesondere Phosphoreszenzemitter bereitgestellt werden, die eine verbesserte Lebensdauer der OLEDs ermöglichen.

Diese Aufgabe wird gelöst durch einen Metallkomplex enthaltend mindestens einen Liganden der allgemeinen Formel (I) 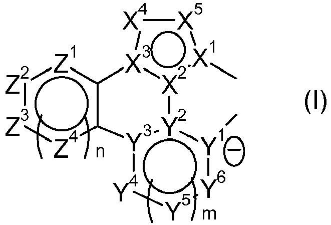 worin die Symbole die folgenden Bedeutungen aufweisen:
- Y⁵, Z⁴: unabhängig voneinander CD, CR¹, CH, N;
- X¹,: N;
- X², X³, Y¹, Y², Y³: unabhängig voneinander N oder C;
- X⁵: CD,
- X⁴: CD oder CR¹;
- Y⁴, Y⁶: unabhängig voneinander CD, CR¹, CH, N; wobei Y⁴ oder Y⁶ im Falle von m = 0 des Weiteren S, O oder NR¹ bedeuten können;
- Z¹, Z², Z³: unabhängig voneinander CD, CR¹, CH, N; wobei Z¹, Z² oder Z³ im Falle von n = 0 des Weiteren S, O oder NR¹ bedeuten können;
- R¹: unabhängig voneinander unsubstituiertes oder substituiertes Alkyl, unsubstituiertes oder substituiertes Cycloalkyl, unsubstituiertes oder substituiertes Heterocycloalkyl, unsubstituiertes oder substituiertes Aryl, unsubstituiertes oder substituiertes Heteroaryl, unsubstituiertes oder substituiertes Alkenyl, unsubstituiertes oder substituiertes Cycloalkenyl, unsubstituiertes oder substituiertes Alkinyl, SiR²₃, Halogen, ein Substituent mit Donor- oder Akzeptorwirkung wobei in dem Fall, wenn R¹ an ein N-Atom gebunden ist, R¹ unabhängig voneinander unsubstituiertes oder substituiertes Alkyl oder unsubstituiertes oder substituiertes Aryl oder unsubstituiertes oder substituiertes Heteroaryl bedeutet, wobei zwei beliebige Reste R¹ des Weiteren gemeinsam eine Alkylen- oder Arylenbrücke bilden können;
- R²: unabhängig voneinander unsubstituiertes oder substituiertes Alkyl oder unsubstituiertes oder substituiertes Aryl oder unsubstituiertes oder substituiertes Heteroaryl;
- m, n: unabhängig voneinander 0 oder 1, wobei die Gruppen Z⁴ bzw. Y⁵ bei n bzw. m = 0 nicht vorhanden sind.

Der Metallkomplex enthält somit mindestens ein Deuteriumatom.

Gemäß der vorliegenden Erfindung weist der Ligand der Formel (I) mindestens ein Deuteriumatom auf. Einer oder mehrere weitere gegebenenfalls in dem erfindungsgemäßen Metallkomplex vorliegende Liganden können ebenfalls mindestens ein Deuteriumatom aufweisen. Der Ligand der Formel (I) enthält mindestens ein Deuteriumatom. Dabei kann ein Deuteriumatom in einem oder mehreren der Reste R¹ und/oder R² vorliegen. Mindestens eine der Gruppen X⁴, X⁵, Y⁴, Y⁵, Y⁶, Z¹, Z², Z³, Z⁴ bedeutet CD, denn die Gruppe X⁵ bedeutet CD.

Es wurde gefunden, dass für die Verwendung in OLEDs geeignete Metallkomplexe bereitgestellt werden können, wobei sich die OLEDs durch ein ausgewogenes Eigenschaftsspektrum, z. B. durch gute Effizienzen, eine hervorragende Lebensdauer und sehr gute Stabilitäten im Device sowie gute Ladungstransporteigenschaften und thermische Stabilität gegenüber im Stand der Technik bekannten OLEDs auszeichnen. Insbesondere können bei Verwendung der erfindungsgemäßen Metallkomplexe OLEDs bereitgestellt werden, die im blauen Bereich des elektromagnetischen Spektrums Licht emittieren.

Die erfindungsgemäßen Metallkomplexe können in jeder Schicht einer OLED eingesetzt werden, wobei das Ligandgerüst oder Zentralmetall zur Anpassung an gewünschte Eigenschaften der Metallkomplexe variiert werden kann. Beispielsweise ist der Einsatz der erfindungsgemäßen Metallkomplexe in der Licht-emittierenden Schicht, einer Blockschicht für Elektronen, einer Blockschicht für Excitonen, einer Blockschicht für Löcher, einer Lochtransportschicht und/oder einer Elektronentransportschicht der OLED in Abhängigkeit von dem Substitutionsmuster der erfindungsgemäßen Metallkomplexe und den elektronischen Gegebenheiten in weiteren in der OLED vorliegenden Schichten möglich. Bevorzugt werden die erfindungsgemäßen Metallkomplexe in der Licht-emittierenden Schicht eingesetzt. Darin können die erfindungsgemäßen Metallkomplexe als Emittermaterialien und/oder Matrixmaterialien eingesetzt werden. Bevorzugt werden die erfindungsgemäßen Metallkomplexe als Emittermaterialien in OLEDs eingesetzt.

Im Sinne der vorliegenden Anmeldung haben die Begriffe unsubstituierter oder substituierter Arylrest oder -gruppe, unsubstituierter oder substituierter Heteroarylrest oder -gruppe, unsubstituierter oder substituierter Alkylrest oder -gruppe, unsubstituierter oder substituierter Cycloalkylrest oder -gruppe, unsubstituierter oder substituierter Heterocycloalkylrest oder -gruppe, unsubstituierter oder substituierter Alkenylrest oder -gruppe, unsubstituierter oder substituierter Alkinylrest oder -gruppe, Aralkylrest oder -gruppe, und Gruppen mit Donor- und/oder Akzeptorwirkung die folgenden Bedeutungen:
Unter einem Arylrest (oder -gruppe) ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind zum Beispiel Deuterium, Alkylreste, bevorzugt Alkylreste mit 1 bis 8 Kohlenstoffatomen, besonders bevorzugt Methyl, Ethyl oder i-Propyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste, Alkenylreste, bevorzugt Alkenylreste, die eine Doppelbindung tragen, besonders bevorzugt Alkenylreste mit einer Doppelbindung und 1 bis 8 Kohlenstoffatomen, oder Gruppen mit Donor- oder Akzeptorwirkung. Die vorstehend genannten Alkylreste, Arylreste, Heteroarylreste, Alkenylreste und Gruppen mit Donor- oder Akzeptorwirkung können an einer oder mehreren Positionen deuteriert sein. Geeignete Gruppen mit Donor- oder Akzeptorwirkung sind nachstehend genannt. Ganz besonders bevorzugt tragen die substituierten Arylreste Substituenten ausgewählt aus der Gruppe bestehend aus Deuterium, Methyl, Isopropyl, F, CN, Aryloxy und Alkoxy, Thioaryl, Thioalkyl, Heteroaryl. Bevorzugt ist der Arylrest oder die Arylgruppe ein C₆-C₁₈-Arylrest, besonders bevorzugt ein C₆-Arylrest, der gegebenenfalls mit mindestens einem oder mehreren der vorstehend genannten Substituenten substituiert ist. Besonders bevorzugt weist der C₆-C₁₈-Arylrest, bevorzugt C₆-Arylrest, keinen, einen, zwei, drei oder vier der vorstehend genannten Substituenten auf.

Unter einem Heteroarylrest oder einer Heteroarylgruppe sind Reste zu verstehen, die sich von den vorstehend genannten Arylresten dadurch unterscheiden, dass in dem Grundgerüst der Arylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Arylreste durch Heteroatome ersetzt. Insbesondere bevorzugt ist das Grundgerüst ausgewählt aus Systemen wie Pyridin und fünfgliedrigen Heteroaromaten wie Pyrrol, Furan, Pyrazol, Imidazol, Thiophen, Oxazol, Thiazol, Triazol. Das Grundgerüst kann an einer, mehreren oder allen substituierbaren Positionen des Grundgerüsts substituiert sein. Geeignete Substituenten sind dieselben, die bereits bezüglich der Arylgruppen genannt wurden.

Unter einem Alkylrest oder einer Alkylgruppe ist ein Rest mit 1 bis 20 Kohlenstoffatomen, bevorzugt 1 bis 10 Kohlenstoffatomen, besonders bevorzugt 1 bis 8, ganz besonders bevorzugt 1 bis 4 Kohlenstoffatomen zu verstehen. Dieser Alkylrest kann verzweigt oder unverzweigt sein und gegebenenfalls mit einem oder mehreren Heteroatomen, bevorzugt Si, N, O oder S, besonders bevorzugt N, O oder S, unterbrochen sein. Des Weiteren kann dieser Alkylrest mit einem oder mehreren der bezüglich der Arylgruppen genannten Substituenten substituiert sein. Es ist ebenfalls möglich, dass der Alkylrest eine oder mehrere (Hetero-)-Arylgruppen trägt. Im Sinne der vorliegenden Anmeldung stellen z. B. Benzylreste somit substituierte Alkylreste dar. Dabei sind alle der vorstehend aufgeführten (Hetero-)Arylgruppen geeignet. Besonders bevorzugt sind die Alkylreste ausgewählt aus der Gruppe bestehend aus Methyl, Ethyl, iso-Propyl, n-Propyl, n-Butyl, iso-Butyl und tert-Butyl, ganz besonders bevorzugt sind Methyl, iso-Propyl, sowie den entsprechenden teilweise oder vollständig deuterierten Derivaten, z. B. CD₃, -C(CD₃)₂D oder -C(CD₃)₃.

Unter einem Cycloalkylrest oder einer Cycloalkylgruppe ist ein Rest mit 3 bis 20 Kohlenstoffatomen, bevorzugt 3 bis 10 Kohlenstoffatomen, besonders bevorzugt 3 bis 8 Kohlenstoffatomen zu verstehen. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind die bereits vorstehend bezüglich der Arylreste genannten Gruppen. Beispiele für geeignete Cycloalkylreste sind Cyclopropyl, Cyclopentyl und Cyclohexyl.

Unter einem Heterocycloalkylrest oder einer Heterocycloalkylgruppe sind Reste zu verstehen, die sich von den vorstehend genannten Cycloalkylresten dadurch unterscheiden, dass in dem Grundgerüst der Cycloalkylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Cycloalkylreste durch Heteroatome ersetzt. Beispiele für geeignete Heterocycloalkylreste sind Reste abgeleitet von Pyrrolidin, Piperidin, Piperazin, Tetrahydrofuran, Dioxan.

Unter einem Alkenylrest oder einer Alkenylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Doppelbindung ersetzt ist. Bevorzugt weist der Alkenylrest eine oder zwei Doppelbindungen auf.

Unter einem Alkinylrest oder einer Alkinylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Dreifachbindung ersetzt ist. Bevorzugt weist der Alkinylrest eine oder zwei Dreifachbindungen auf.

Die Begriffe Alkylen und Arylen haben im Sinne der vorliegenden Anmeldung die bezüglich der Alkyl-, und Arylreste genannten Bedeutungen mit dem Unterschied, dass die Alkylen-, und Arylengruppen zwei Bindungsstellen aufweisen.

Bevorzugte Alkylengruppen sind (CR⁴**₂**)ₙ, wobei R⁴ Deuterium, H oder Alkyl, bevorzugt Deuterium, H, Methyl oder Ethyl, besonders bevorzugt H oder D und n 1 bis 3, bevorzugt 1 oder 2, besonders bevorzugt 1 bedeutet. Ganz besonders bevorzugt ist die Alkylengruppe CH₂ oder CD₂.

Bevorzugte Arylengruppen sind 1,2-, 1,3- oder 1,4-Phenylengruppen, die unsubstituiert sind oder die bezüglich der Arylreste genannten Substituenten tragen können.

Unter einer Gruppe oder einem Substituenten mit Donor- oder Akzeptorwirkung sind im Sinne der vorliegenden Anmeldung die folgenden Gruppen zu verstehen:
Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I- und/oder -M-Effekt aufweisen. Geeignete Gruppen mit Donor- oder Akzeptorwirkung sind Halogenreste, bevorzugt F, Cl, Br, besonders bevorzugt F, Alkoxyreste oder Aryloxyreste, OR², Carbonylreste, Esterreste, sowohl Oxycarbonyl als auch Carbonyloxy, Aminogruppen, NR₂², Amidreste, CH₂F-Gruppen, CHF₂-Gruppen, CF₃-Gruppen, CN-Gruppen, Thiogruppen, Sulfonsäuregruppen, Sulfonsäureestergruppen, Boronsäuregruppen, Boronsäureestergruppen, Phosphonsäuregruppen, Phosphonsäureestergruppen, Phosphinreste, Sulfoxidreste, Sulfonylreste, Sulfidreste, SR², Nitrogruppen, OCN, Boranreste, Silylgruppen, SiR₃², Stannatreste, Iminogruppen, Hydrazinreste, Hydrazonreste, Oximreste, Nitrosogruppen, Diazogruppen, Phosphinoxidgruppen, Hydroxygruppen oder SCN-Gruppen. Ganz besonders bevorzugt sind F, Cl, CN, Aryloxy, Alkoxy, Amino, CF₃-Gruppen, Sulfonyl, Silyl, Sulfid und Heteroaryl. Insbesondere ganz besonders bevorzugt sind Heteroaryl, Silyl (SiR₃²), F, Alkoxy oder Aryloxy (OR²), Sulfidreste (SR²), Amino (NR₂²) und CN. Die Reste R² sind nachstehend definiert.

Die vorstehend genannten Gruppen mit Donor- oder Akzeptorwirkung schließen nicht aus, dass weitere der in der vorliegenden Anmeldung genannte Reste und Substituenten, die nicht in der vorstehenden Liste der Gruppen mit Donor- oder Akzeptorwirkung aufgeführt sind, eine Donor- oder Akzeptorwirkung aufweisen.

Die Arylreste oder -gruppen, Heteroarylreste oder -gruppen, Alkylreste oder -gruppen, Cycloalkylreste oder -gruppen, Heterocycloalkylreste oder -gruppen, Alkenylreste oder -gruppen, Alkinylreste oder -gruppen und Gruppen mit Donor- und/oder Akzeptorwirkung, sowie die Alkylen- und Arylenreste oder -gruppen können - wie vorstehend erwähnt - substituiert oder unsubstituiert sein. Unter einer unsubstituierten Gruppe ist im Sinne der vorliegenden Anmeldung eine Gruppe zu verstehen, worin die substituierbaren Atome der Gruppe Wasserstoffatome tragen. Unter einer substituierten Gruppe ist im Sinne der vorliegenden Anmeldung eine Gruppe zu verstehen, worin ein oder mehrere substituierbare Atom(e) mindestens an einer Position anstelle eines Wasserstoffatoms einen Substituenten tragen. Geeignete Substituenten sind die vorstehend bezüglich der Arylreste oder-gruppen genannten Substituenten.

Kommen Reste mit denselben Nummerierungen mehrfach in den Verbindungen gemäß der vorliegenden Anmeldung vor, so können diese Reste jeweils unabhängig voneinander die genannten Bedeutungen aufweisen.

Die Symbole X¹, X², X³, X⁴, X⁵, Y¹, Y², Y³, Y⁴, Y⁵, Y⁶, Z¹, Z², Z³, Z⁴ weisen unabhängig voneinander die folgenden Bedeutungen auf:
- Y⁵, Z⁴: unabhängig voneinander CD, CR¹, CH, N;
- X¹: N;
- X², X³, Y¹, Y², Y³: unabhängig voneinander N oder C;
- X⁴: CD oder CR¹;
- X⁵: CD;
- Y⁴, Y⁶: unabhängig voneinander CD, CR¹, CH, N; wobei Y⁴ oder Y⁶ im Falle von m = 0 des Weiteren S, O oder NR¹ bedeuten können;
- Z¹, Z², Z³: unabhängig voneinander CD, CR¹, CH, N; wobei Z¹, Z² oder Z³ im Falle von n = 0 des Weiteren S, O oder NR¹ bedeuten können.

Bevorzugt bedeuten 0, 1, 2 der vorstehend genannten Gruppen Y⁴, Y⁶, Z¹, Z² und Z³ S oder O, wobei z. B. Y⁴ und/oder Z¹ in den Liganden der allgemeinen Formel (I) S oder O bedeuten und die übrigen Gruppen die vorstehend genannten Bedeutungen, jedoch nicht S oder O, aufweisen.

Die vorliegende Erfindung betrifft einen Metallkomplex, in dem die Gruppe X¹ N bedeutet und die übrigen vorstehend erwähnten Gruppen die vorstehend genannten Bedeutungen aufweisen.

Ganz besonders bevorzugt weisen die Symbole X¹, X², X³, X⁴, X⁵, Y¹, Y², Y³, Y⁴, Y⁵, Y⁶, Z¹, Z², Z³, Z⁴ unabhängig voneinander die folgenden Bedeutungen auf:
- X², Y¹, Y², Y³: C;
- X¹: N;
- X³: C oder N, bevorzugt N;
- X⁵: CD;
- X⁴: CR¹ oder CD;
- Y⁴, Y⁵, Y⁶: unabhängig voneinander CH, CD oder CR¹, bevorzugt CD;
- Z¹, Z², Z³, Z⁴: unabhängig voneinander CH, CD, CR¹ oder N, wobei Z¹, Z² oder Z³ im Falle von n = 0 des Weiteren S, O oder NR¹ bedeuten können, bevorzugt bedeuten Z¹, Z² und Z⁴ CD und Z³ CR¹.

X¹ bedeutet N und X⁵ oder X⁴ und X⁵ CD, wobei die übrigen vorstehend genannten Gruppen die vorstehend genannten Bedeutungen aufweisen. Ganz besonders bevorzugt bedeuten X¹ und X³ N, wobei bevorzugt X⁵ zusätzlich CD und X⁴ CR¹ bedeutet. Die übrigen vorstehend genannten Gruppen weisen die vorstehend genannten Bedeutungen auf. Insbesondere ganz besonders bevorzugt bedeuten X¹ und X³ N, X⁴ und Z³ CR¹ und X⁵, Y⁴, Y⁵, Y⁶, Z¹, Z² und Z⁴ CD, wobei die übrigen vorstehend erwähnten Gruppen die vorstehend genannten Bedeutungen aufweisen. Ganz besonders bevorzugt weisen die übrigen vorstehend erwähnten Gruppen in dem letztgenannten Fall die Bedeutungen Deuterium oder R¹ auf, wobei R¹ die nachstehend genannten Definitionen aufweisen kann.

R¹ bedeutet in den Liganden der allgemeinen Formel (I) unabhängig voneinander unsubstituiertes oder substituiertes Alkyl, unsubstituiertes oder substituiertes Cycloalkyl, unsubstituiertes oder substituiertes Heterocycloalkyl, unsubstituiertes oder substituiertes Aryl, unsubstituiertes oder substituiertes Heteroaryl, unsubstituiertes oder substituiertes Alkenyl, unsubstituiertes oder substituiertes Cycloalkenyl, unsubstituiertes oder substituiertes Alkinyl, SiR²₃, Halogen, einen Substituenten mit Donor- oder Akzeptorwirkung, wobei in dem Fall, wenn R¹ an ein N-Atom gebunden ist, R¹ unabhängig voneinander unsubstituiertes oder substituiertes Alkyl oder unsubstituiertes oder substituiertes Aryl oder unsubstituiertes oder substituiertes Heteroaryl bedeutet, oder zwei beliebige Reste R¹ können gemeinsam eine Alkylen- oder Arylenbrücke bilden. Dabei können die beiden Reste R¹ zu einem einzigen Zyklus der Liganden der allgemeinen Formel (I) oder zu zwei verschiedenen Zyklen des Liganden der allgemeinen Formel (I) gehören. Z. B. können in dem Fall, wenn X⁴ CR¹ bedeutet, die beiden Reste R¹ gemeinsam eine Alkylen- oder Arylenbrücke bilden. Es ist ebenfalls möglich, dass in dem Fall, wenn Z¹ und X⁴ oder Z⁴ (bei n = 1) bzw. Z³ (bei n = 0) und Y⁴ CR¹ bedeuten, zwei Reste R¹ gemeinsam eine Alkylen- oder Arylenbrücke bilden. Geeignete und bevorzugte Alkyl-, Cycloalkyl-, Heterocycloalkyl-, Aryl-, Heteroaryl-, Alkenyl-, Cycloalkenyl-, Alkinylgruppen sowie Substituenten mit Donor- oder Akzeptorwirkung und Alkylen- und Arylengruppen sind die vorstehend genannten Gruppen. Bevorzugt bedeutet R¹ unabhängig voneinander unsubstituiertes oder substituiertes Alkyl, unsubstituiertes oder substituiertes Aryl, unsubstituiertes oder substituiertes Heteroaryl, SiR²₃, Halogen, bevorzugt F, OR², SR², NR²₂, CF₃ oder CN, wobei R¹ in dem Fall, wenn R¹ an ein N-Atom gebunden ist, bevorzugt unabhängig voneinander unsubstituiertes oder substituiertes Alkyl, unsubstituiertes oder substituiertes Aryl bedeutet. Ganz besonders bevorzugt bedeutet R¹ unabhängig voneinander unsubstituiertes oder substituiertes Alkyl, unsubstituiertes oder substituiertes Aryl, unsubstituiertes oder substituiertes Heteroaryl oder SiR₃². Weiter ganz besonders bevorzugt bedeutet R¹ Methyl, iso-Propyl, oder deren entsprechende teilweise oder vollständig deuterierte Derivate, z. B. CD₃, -C(CD₃)₂D oder -C(CD₃)₃; unsubstituiertes oder substituiertes C₆-Aryl, wobei als Substituenten insbesondere Deuterium, Methyl, Isopropyl, CD₃, -C(CD₃)₂D oder -C(CD₃)₃ geeignet sind, wobei ortho-disubstituierte C₆-Aryle besonders bevorzugt sind; oder C₅- oder C₆-Heteroaryl, z. B. 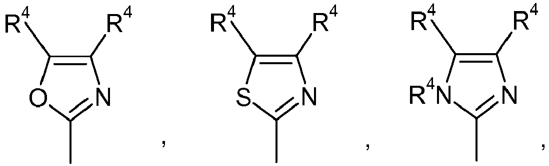 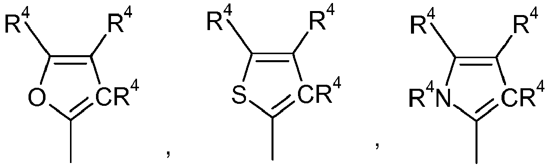 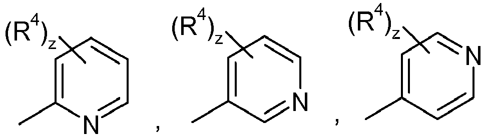 worin
- R⁴: unabhängig voneinander unsubstituiertes oder substituiertes Alkyl, unsubstituiertes oder substituiertes Aryl, unsubstituiertes oder substituiertes Heteroaryl oder SiR²₃ bedeutet, bevorzugt Wasserstoff, Deuterium, Methyl, Ethyl, n-Propyl, isoPropyl, n-Butyl, sec-Butyl, iso-Butyl, tert-Butyl oder deren teilweise oder vollständig deuterierte Derivate, z. B. CD₃, -C(CD₃)₂D oder -C(CD₃)₃; unsubstituiertes oder substituiertes C₆-Aryl oder C₅- oder C₆-Heteroaryl, besonders bevorzugt Wasserstoff oder Deuterium; und
- z: 0, 1, 2, 3 oder 4, bevorzugt 0, 1 oder 2;
bedeuten;
wobei R¹ in dem Fall, wenn R¹ an ein N-Atom gebunden ist, besonders bevorzugt unabhängig voneinander Methyl, Ethyl, iso-Propyl, n-Propyl, n-Butyl, iso-Butyl, sec-Butyl oder tert.-Butyl oder C₆-Aryl, das unsubstituiert oder substituiert sein kann, bevorzugt Phenyl oder Tolyl, bedeutet.

R² bedeutet unabhängig voneinander unsubstituiertes oder substituiertes Alkyl oder unsubstituiertes oder substituiertes Aryl, wobei geeignete und bevorzugte Alkyl- und Arylreste sowie geeignete Substituenten vorstehend genannt sind. Bevorzugt ist R² Methyl, Ethyl, iso-Propyl, n-Propyl, n-Butyl, iso-Butyl, sec-Butyl oder tert-Butyl oder C₆-Aryl, das unsubstituiert oder substituiert sein kann, bevorzugt Phenyl oder Tolyl.

m und n können in den Liganden der allgemeinen Formel (I) unabhängig voneinander 0 oder 1 bedeuten, wobei die Gruppen Z⁴ bzw. Y⁵ bei n bzw. m = 0 nicht vorhanden sind. Für den Fall von m = 0 ist der aus den Elementen X¹, X², X³, X⁴ und X⁵ gebildete aromatische 5-Ring somit mit einem aus den Elementen Y¹, Y², Y³, Y⁴ und Y⁶ gebildeten 5-Ring verbunden. Für m = 1 ist der aus X¹, X², X³, X⁴ und X⁵ gebildete aromatische 5-Ring mit einem aus den Elementen Y¹, Y², Y³, Y⁴, Y⁵ und Y⁶ gebildeten aromatischen 6-Ring verbunden. Für n = 0 ist der aus X¹, X², X³, X⁴, X⁵ gebildete aromatische 5-Ring mit einem aus Z¹, Z², Z³ und zwei Kohlenstoffatomen gebildeten aromatischen 5-Ring verbunden und für n = 1 ist der aus X¹, X², X³, X⁴ und X⁵ gebildete aromatische 5-Ring mit einem aus Z¹, Z², Z³, Z⁴ und zwei Kohlenstoffatomen gebildeten aromatischen 6-Ring verbunden. Bevorzugt ist m = 1. In einer weiteren bevorzugten Ausführungsform ist n = 1. Besonders bevorzugt sind sowohl n als auch m = 1.

Der erfindungsgemäße Metallkomplex enthält bevorzugt ein Metallatom ausgewählt aus der Gruppe bestehend aus Übergangsmetallen der Gruppe IB, IIB, IIIB, IVB, VB, VIB, VIIB, VIII des Periodensystems der Elemente (CAS-Version), in jeder für das entsprechende Metallatom möglichen Oxidationsstufe. Bevorzugt enthalten die erfindungsgemäßen Metallkomplexe ein Metallatom M ausgewählt aus der Gruppe bestehend aus Ir, Co, Rh, Ni, Pd, Pt, Fe, Ru, Os, Cr, Mo, W, Mn, Tc, Re, Ag, Au und Cu, besonders bevorzugt Ir, Os, Ru, Rh, Pd, Co, Ni und Pt, ganz besonders bevorzugt Ir, Pt, Rh, Ru und Os, in jeder für das entsprechende Metallatom möglichen Oxidationsstufe. Insbesondere bevorzugt werden Pt(II), Pt(IV), Ir(I), Ir(III), Os(ll) und Ru(II), weiter insbesondere bevorzugt Pt(II), Ir(III) und Os(II) und ganz besonders bevorzugt Ir(III) eingesetzt.

Neben dem mindestens einen Liganden der allgemeinen Formel (I) kann der erfindungsgemäße Metallkomplex weitere von dem Liganden der allgemeinen Formel (I) verschiedene Liganden enthalten. Beispielsweise können neben dem mindestens einen Liganden der allgemeinen Formel (I) einer oder mehrere neutrale mono- oder bidentate Liganden K sowie gegebenenfalls einer oder mehrere mono- oder dianionische Liganden J, die mono- oder bidentat sein können, vorliegen. Des Weiteren können unterschiedliche Liganden der Formel (I) in dem erfindungsgemäßen Metallkomplex vorliegen. Dabei ist unter einem bidentaten Liganden ein Ligand zu verstehen, der an zwei Stellen an das Metallatom M koordiniert ist. Im Sinne der vorliegenden Anmeldung wird der Begriff "zweizähnig" synonym mit dem Begriff "bidentat" verwendet.

Unter einem monodentaten Liganden ist ein Ligand zu verstehen, der an einer Stelle des Liganden mit dem Metallatom M koordiniert ist.

Somit betrifft die vorliegende Erfindung in einer bevorzugten Ausführungsform Metallkomplexe der allgemeinen Formel (II) 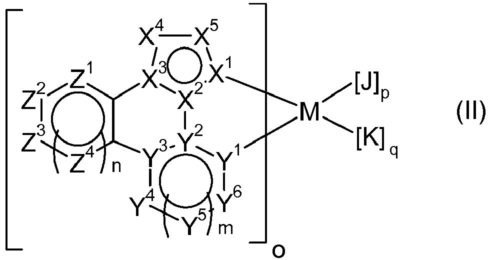 worin bedeuten:
- M: Metallatom ausgewählt aus der Gruppe bestehend aus Übergangsmetallen der Gruppe IB, IIB, IIIB, IVB, VB, VIB, VIIB, VIII des Periodensystems der Elemente (CAS-Version), in jeder für das entsprechende Metallatom möglichen Oxidationsstufe; bevorzugt Ir(III), Pt(II) oder Os(II), besonders bevorzugt Ir(III);
- J: mono- oder dianionischer Ligand, der mono- oder bidentat sein kann, bevorzugt bidentater, monoanionischer Ligand;
- K: neutraler, mono- oder bidentater Ligand, der im Allgemeinen nicht photoaktiv ist: bevorzugte Liganden K sind Phosphine, insbesondere Trialkylphosphine, z. B. PEt₃, PnBu₃, Triarylphosphine, z. B. PPh₃; Phosphonate und Derivate davon, Arsenate und Derivate davon, Phosphite, CO, Nitrile, Amine, Diene, die einen π-Komplex mit M bilden können, z. B. 2,4-Hexadien, η⁴-Cyciooctadien und η²-Cyclooctadien (jeweils 1,3 und 1,5), Allyl, Methallyl, Cycloocten, Norbornadien und neutrale Biscarbene, z. B. die in WO 2008/000726 offenbarten neutralen Biscarbene;
- o: 1, 2, 3 oder 4; wobei o für M = Ir(III) 1, 2 oder 3, bevorzugt 2 oder 3; für M = Pt(II) oder Os(II) 1 oder 2; bedeutet;
- p: 0, 1, 2, 3 oder 4; wobei p für M = Ir(III) 0, 1 2, 3 oder 4, bevorzugt 0 oder 2; für M = Pt(II) und Os(II) 0, 1 oder 2, bevorzugt 0 oder 2; bedeutet, wobei p die Zahl der Bindungsstellen zum Metall M bedeutet, d.h., wenn p = 2 ist, kann es sich um zwei monodentate oder einen bidentaten Liganden handeln;
- q: 0, 1, 2, 3 oder 4; wobei q für M = Ir(III) 0, 1 oder 2, bevorzugt 0; für M = Pt(II) 0 oder 1, bevorzugt 0; für Os(ll) 2 oder 3, bevorzugt 2 bedeutet, wobei q die Zahl der Bindungsstellen zum Metall M bedeutet, d.h., wenn q= 2 ist, kann es sich um zwei monodentate oder einen bidentaten Liganden handeln;
wobei o, p und q von der Oxidationsstufe und Koordinationszahl des eingesetzten Metallatoms und der Ladung der Liganden abhängig sind.

Sowohl der Ligand J als auch der Ligand K kann ein oder mehrere Deuteriumatome aufweisen.

Für den Fall, dass die Zahl o, p oder q > 1 ist, können die eingesetzten Liganden der Formel (I), K oder J jeweils gleich oder verschieden sein.

Für M = Ir(III) ist die Summe o, p + q in den erfindungsgemäßen Metallkomplexen der Formel (II) im Allgemeinen 3, 4 oder 5, d.h. in dem Fall, wenn 3 Liganden der Formel I vorliegen, ist o 3 und wenn 2 Liganden der Formel I und z. B. 1 bidentater, monoanionischer Ligand J vorliegt, ist o 2 und p 2. Für M = Pt(II) ist die Summe o + p im Allgemeinen 2 oder 3, d.h. in dem Fall, wenn 2 Liganden der Formel I vorliegen, ist o 2 und wenn 1 Ligand der Formel I und z. B. 1 bidentater, monoanionischer Ligand J vorliegt, ist o 1 und p 2, wobei o jeweils mindestens 1 ist. Für Os(II) ist die Summe o, p + q in den erfindungsgemäßen Metallkomplexen der Formel (II) im Allgemeinen 4 oder 5, d. h. wenn 2 Liganden der Formel (I) und z. B. 1 bidentater, neutraler Ligand K vorliegt, ist o 2 und q 2, und in dem Fall, wenn z. B. 1 Ligand der Formel (I), 1 bidentater, monoanionischer Ligand J und 1 neutraler bidentater Ligand K vorliegen, ist o 1, p 2 und q 2.

Die Symbole X¹, X², X³, X⁴, X⁵, Y¹, Y², Y³, Y⁴, Y⁵, Y⁶, Z¹, Z², Z³, Z⁴, m und n in dem Metallkomplex der Formel (II) weisen die vorstehend genannten Bedeutungen auf.

Falls verschiedene Isomere der erfindungsgemäßen Metallkomplexe vorliegen können, umfasst die vorliegende Erfindung sowohl jeweils die einzelnen Isomere der Metallkomplexe, als auch Gemische verschiedener Isomere in jedem beliebigen Mischungsverhältnis. Im Allgemeinen können verschiedene Isomere der Metallkomplexe nach dem Fachmann bekannten Verfahren, z. B. durch Chromatographie, Sublimation oder Kristallisation, getrennt werden.

Üblicherweise werden als bidentate, monoanionische Liganden J nicht photoaktive oder photoaktive (z. B. heteroleptische Komplexe mit Carbenen, Phenylpyridinen oder Phenylimidazolen) Liganden eingesetzt. Geeignete Liganden J sind z. B. bidentate, monoanionische Liganden der allgemeinen Formel 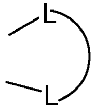 , worin L jeweils unabhängig voneinander ausgewählt ist aus O, N und C. Bevorzugt sind bidentate, monoanionische Liganden J, worin beide Gruppen L O, C oder N bedeuten, oder eine Gruppe L O bedeutet und die andere Gruppe L N oder C bedeutet, oder eine Gruppe L C bedeutet und die anderen Gruppe L N bedeutet. Besonders bevorzugte bidentate, monoanionische Liganden sind Acetylacetonat und dessen Derivate, Picolinat und dessen Derivate, bidentate, monoanionische Carbenliganden und deren Derivate, z. B. Carbenliganden, die in WO 2005/019373, WO 2005/0113704, WO 2006/018292, WO 2006/056418, WO 2007/115981, WO 2007/115970, WO 2008/000727, WO 2006/067074, WO 2006/106842, WO 2007/018067, WO 2007/058255, WO 2007/069542, US 2007/108891, WO 2007/058080, WO 2007/058104 genannt sind, sowie die in WO 02/15645, WO 2005/123873, US 2007/196690, WO 2006/121811 genannten bidentaten, monoanionischen Liganden. Besonders bevorzugt sind die bidentaten, monoanionischen Liganden ausgewählt aus der Gruppe bestehend aus Acetylacetonat, Picolinat, Carbenen wie N-Methyl-N-arylimidazolcarben, Arylpyridinen wie 2-Arylpyridinen, insbesondere Phenylpyridinen wie 2-Phenylpyridin, Arylimidazolen wie 2-Arylimidazolen, insbesondere Phenylimidazolen, wie 2-Phenylimidazol und Derivaten der vorstehend genannten Verbindungen. In den vorstehend genannten bidentaten, monoanionischen Liganden können eine oder mehrere Wasserstoffatome der Liganden durch Deuterium ersetzt sein.

In einer besonders bevorzugten Ausführungsform weist der erfindungsgemäße Metallkomplex die allgemeine Formel (IIa) auf. 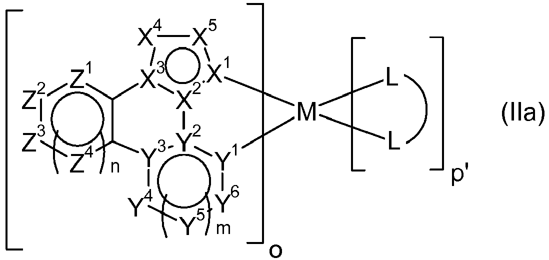 worin bedeuten:
- M: Metallatom ausgewählt aus der Gruppe bestehend aus Übergangsmetallen der Gruppe IB, IIB, IIIB, IVB, VB, VIB, VIIB, VIII des Periodensystems der Elemente (CAS-Version), in jeder für das entsprechende Metallatom möglichen Oxidationsstufe; bevorzugt Ir(III), Pt(II), besonders bevorzugt Ir(III); 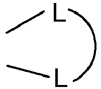 bidentater monoanionischer Ligand, der einen oder mehrere Deuteriumatome aufweisen kann; bevorzugt ist L in dem bidentaten monoanionischen Liganden jeweils unabhängig voneinander ausgewählt aus O, N und C; besonders bevorzugt sind bidentate monoanionische Liganden, worin beide Gruppen L O, C oder N bedeuten oder eine Gruppe L O bedeutet und die andere Gruppe L N oder C bedeutet oder eine Gruppe L C bedeutet und die andere Gruppe L N bedeutet; ganz besonders bevorzugt sind die bidentaten monoanionischen Liganden ausgewählt aus der Gruppe bestehend aus Acetylacetonat, Picolinat, Carbenen wie N-Methyl-N-arylimidazolcarben, Arylpyridinen wie 2-Arylpyridinen, insbesondere Phenylpyridinen wie 2-Phenylpyridin und Arylimidazolen wie 2-Arylimidazolen, insbesondere Phenylimidazolen, wie 2-Phenylimidazol und Derivaten der vorstehend genannten Verbindungen
- o: 1, 2, 3, 4; wobei o für M = Ir(III) 1, 2 oder 3, bevorzugt 2 oder 3; für M = Pt(II) 1 oder 2; bedeutet
- p': 0, 1 oder 2; wobei p für M = Ir(III) 0, 1 oder 2, bevorzugt 0 oder 1; für M = Pt(II) 0 oder 1; bedeutet, wobei p' die Zahl der Liganden tet; 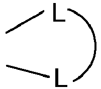 bedeu-tet;
wobei o und p' von der Oxidationsstufe und Koordinationszahl des eingesetzten Metallatoms abhängig sind.

Für M = Ir(III) ist die Summe o + p' in den erfindungsgemäßen Metallkomplexen der Formel (IIa) im Allgemeinen 3, und für M = Pt(II) ist die Summe o + p' im Allgemeinen 2, wobei o jeweils mindestens 1 ist.

Die Symbole X¹, X², X³, X⁴, X⁵, Y¹, Y², Y³, Y⁴, Y⁵, Y⁶, Z¹, Z², Z³, Z⁴, m und n in dem Metallkomplex der Formel (IIa) weisen die vorstehend genannten Bedeutungen auf. Des Weiteren sind weitere Ausführungsformen von M, des bidentaten, monoanionischen Liganden sowie von o und p' die vorstehend für M, den bidentaten, monoanionischen Liganden, o und p' (bzw. p, wobei p' = 1 p = 2 entspricht) genannten Ausführungsformen.

In einer besonders bevorzugten Ausführungsform betrifft die vorliegende Erfindung Metallkomplexe der Formel (IIaa) 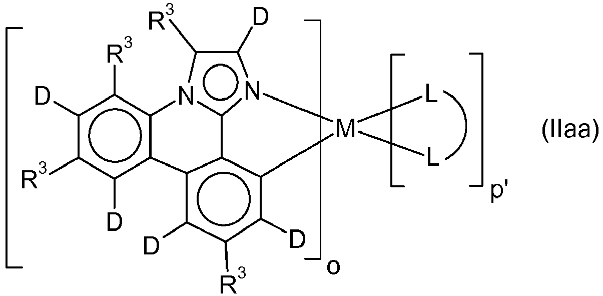 worin M, o und p' die vorstehend genannten Bedeutungen aufweisen;
- D: Deuterium, und

- R³: unabhängig voneinander Deuterium oder R¹ bedeutet.

Geeignete Ausführungsformen für R¹ sind vorstehend genannt.

Im Folgenden sind beispielhaft bevorzugte erfindungsgemäße Metallkomplexe der Formel (IIa) bzw. (IIaa) aufgeführt.

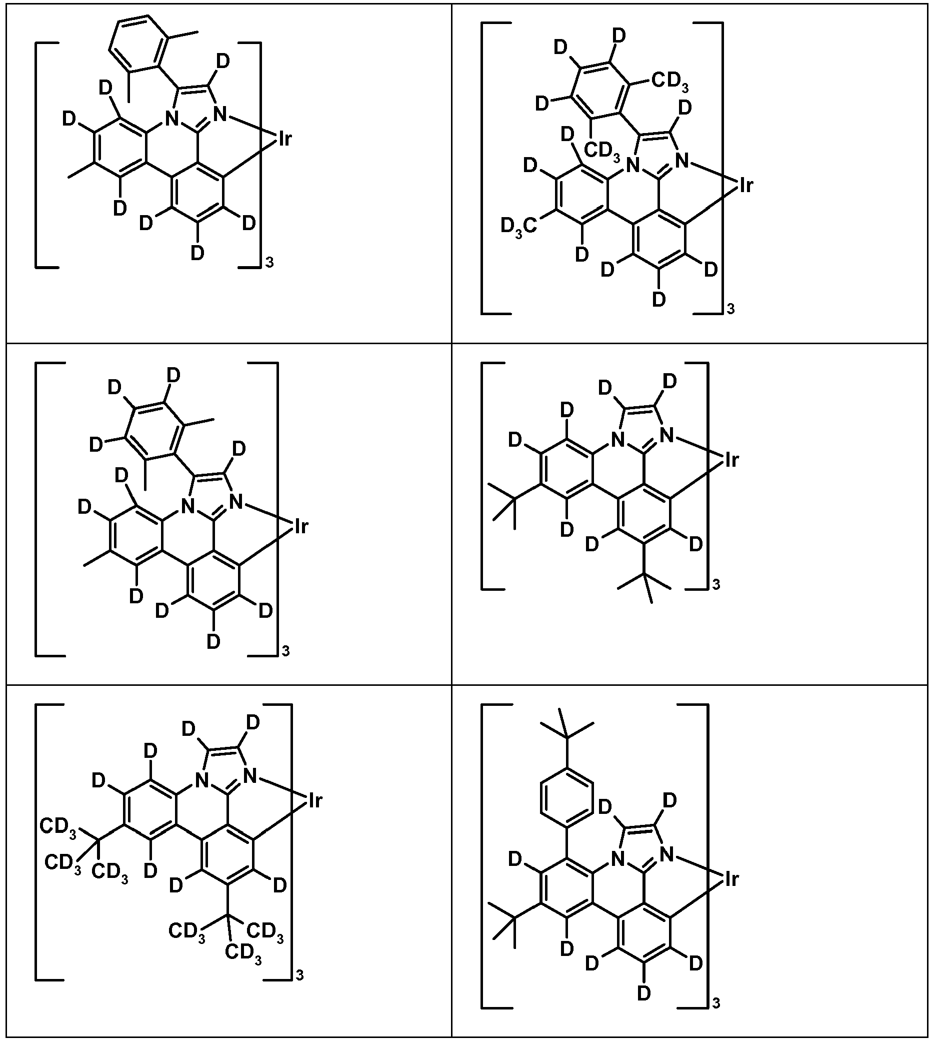

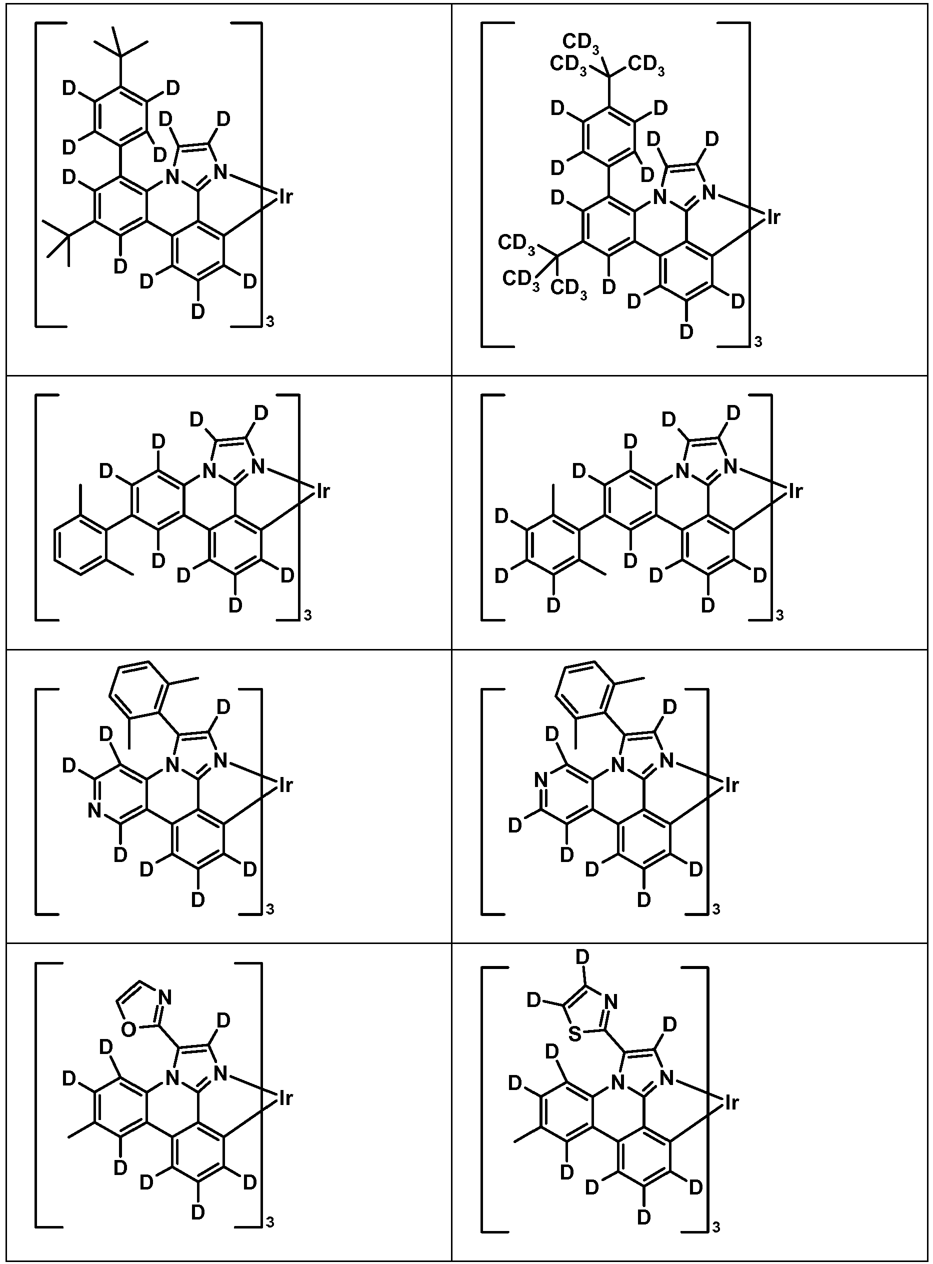

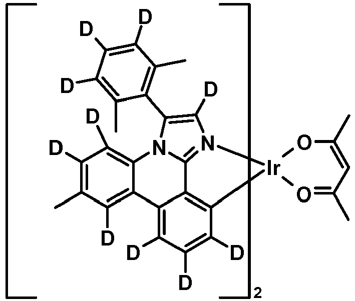

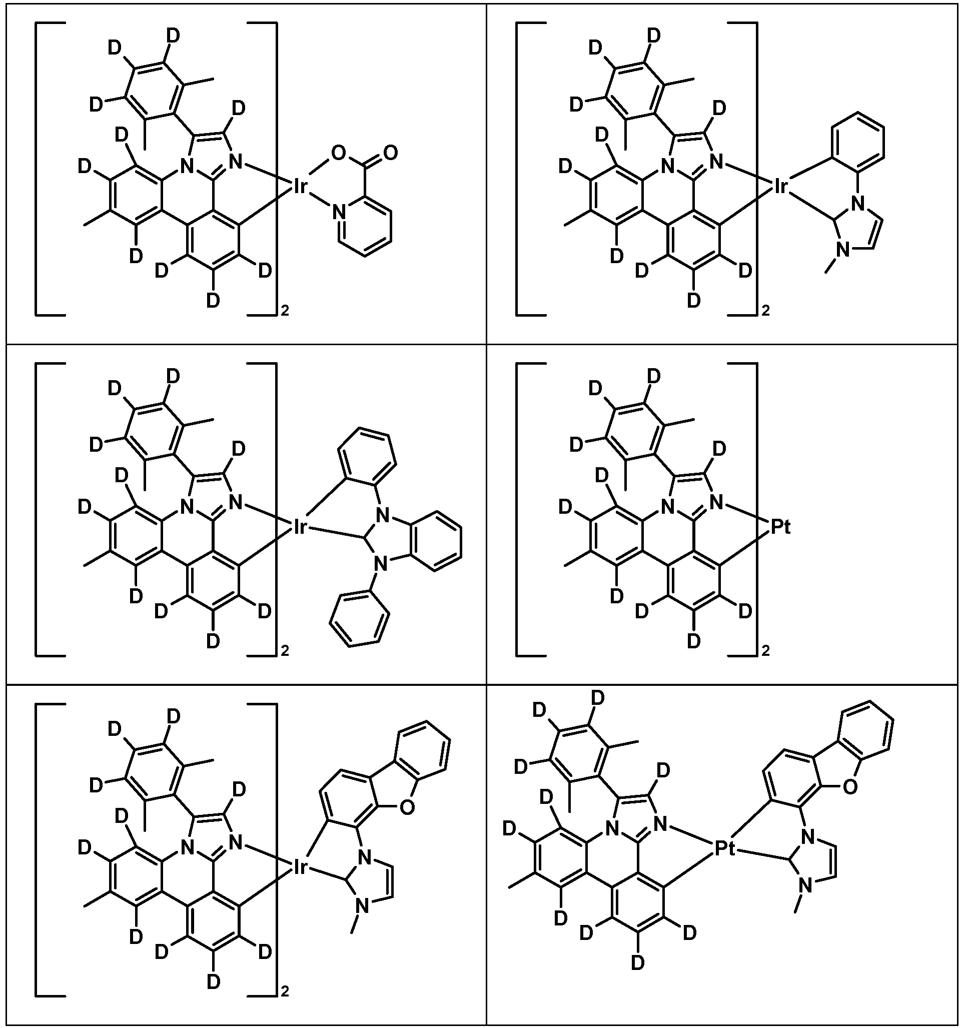

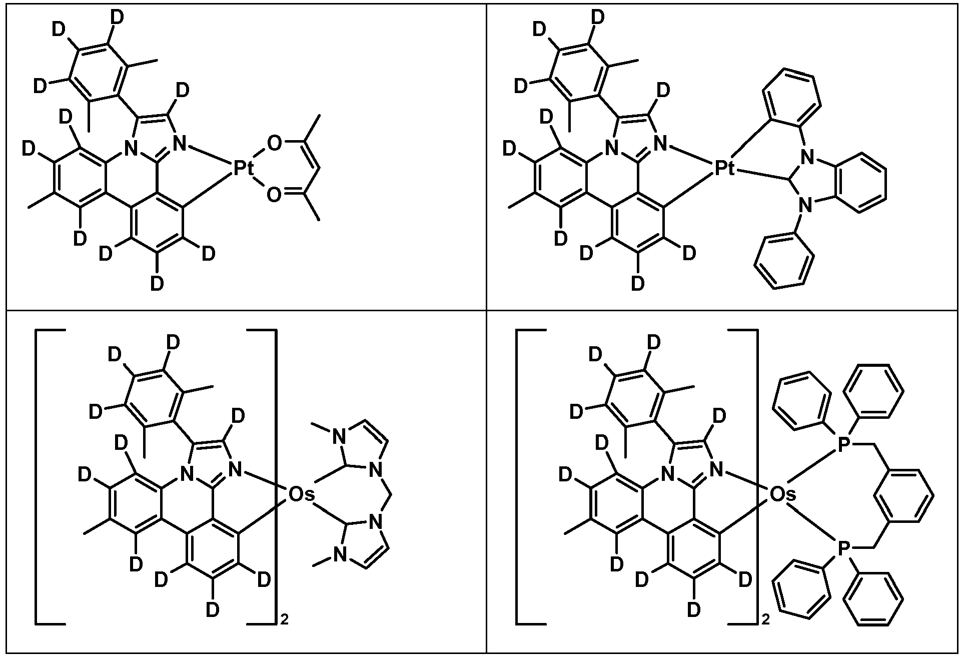

Im Folgenden sind weitere Beispiele für bevorzugte erfindungsgemäße Metallkomplexe genannt:

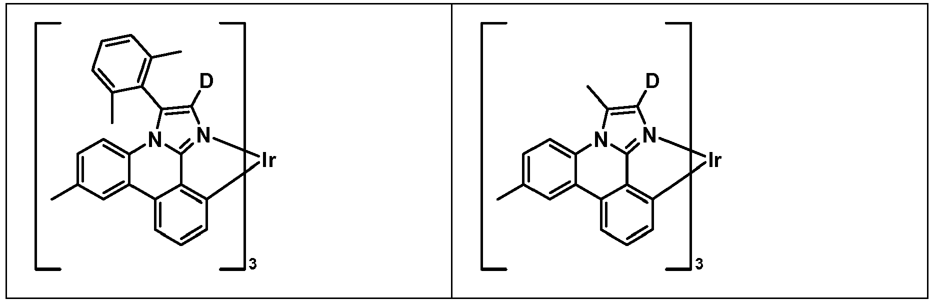

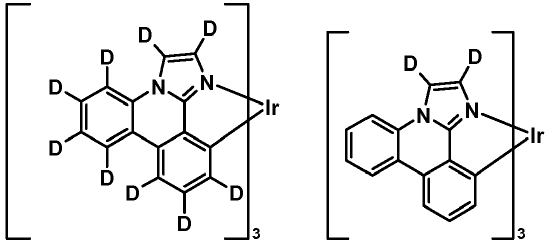

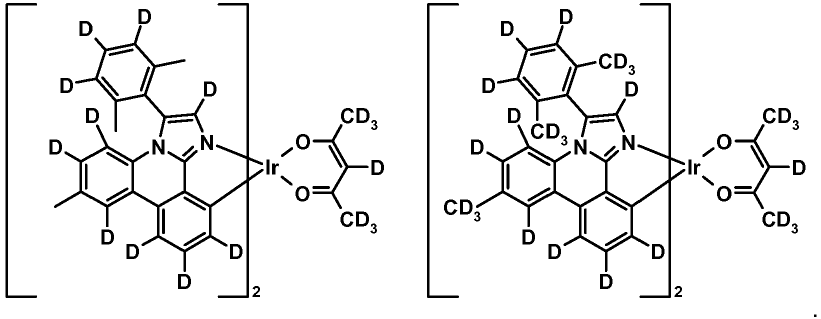

Die erfindungsgemäßen Metallkomplexe können gemäß dem Fachmann bekannten Verfahren bzw. analog zu dem Fachmann bekannten Verfahren hergestellt werden. Geeignete Herstellungsverfahren sind z. B. analog zu in den Beispielen von WO 2007/095118 genannten Verfahren, wobei die Herstellung der erfindungsgemäßen Metallkomplexe zusätzlich den Schritt der Einführung mindestens eines Deuteriumatoms in den Metallkomplex umfasst. Die Einbringung von Deuteriumatomen in den Liganden der Formel (I) des erfindungsgemäßen Metallkomplexes erfolgt gemäß dem Fachmann bekannten Verfahren. Geeignete Verfahren zum Austausch von Wasserstoffatomen gegen Deuteriumatome sind z. B. in dem Übersichtsartikel J. Atzrodt, V. Derdau, T. Fey, J. Zimmermann, Angew. Chem. Int. Ed. 2007, 46, 7744-7765 genannt.

Üblicherweise werden die erfindungsgemäßen Metallkomplexe ausgehend von den Liganden der allgemeinen Formel (I) entsprechenden Ligandvorläufern hergestellt. Dabei erfolgt die Herstellung der erfindungsgemäßen Metallkomplexe durch Umsetzung von mindestens einem Ligandvorläufer basierend auf den Liganden der allgemeinen Formel (I) mit einem Metallkomplex enthaltend mindestens ein Metall M, wobei M die vorstehend genannten Bedeutungen aufweist.

Das molare Verhältnis zwischen den Ligandvorläufern basierend auf den Liganden der Formel (I) und dem Metallkomplex enthaltend mindestens ein Metall M ist von der Struktur des gewünschten erfindungsgemäßen Metallkomplexes abhängig sowie von der Anzahl der Liganden der Formel (I). In dem Fall, dass o in den erfindungsgemäßen Metallkomplexen > 1 ist, ist es möglich, dass diese Metallkomplexe durch Umsetzung des Metallkomplexes enthaltend mindestens ein Metall M mit identischen Ligandvorläufern oder durch Umsetzung mit verschiedenen Ligandvorläufern erhalten werden. Geeignete Verfahren und Umsetzungsreihenfolgen zur Herstellung der verschiedenen erfindungsgemäßen Metallkomplexe sind dem Fachmann bekannt.

Bei dem mit dem Ligandvorläufer umzusetzenden Metallkomplex enthaltend mindestens ein Metall M handelt es sich um einen Metallkomplex enthaltend mindestens ein Metallatom ausgewählt aus der Gruppe bestehend aus Übergangsmetallen der Gruppe IIB, IIIB, IVB, VB, VIB, VIIB, VIII des Periodensystems der Elemente (CAS-Version) und Cu, bevorzugt ausgewählt aus der Gruppe bestehend aus Ir, Co, Rh, Ni, Pd, Pt, Fe, Ru, Os, Cr, Mo, W, Mn, Tc, Re und Cu, besonders bevorzugt Ir, Os, Ru, Rh, Pd, Co und Pt, ganz besonders bevorzugt Ir, Pt, Rh, Pd, Ru und Os in jeder geeigneten für das entsprechende Metall möglichen Oxidationsstufe.

Geeignete mit dem Ligandvorläufer umzusetzende Metallkomplexe sind dem Fachmann bekannt. Beispiele für geeignete Metallkomplexe sind: Pd(OAc)₂, Pt(cod)Cl₂, Pt(cod)Me₂, Pt(acac)₂, Pt(PPh₃)₂Cl₂, PtCl₂, [Rh(cod)Cl]₂, Rh(acac)CO(PPh₃), Rh(acac)(CO)₂, Rh(cod)₂BF₄, RhCl(PPh₃)₃, RhCl₃ x nH₂O, Rh(acac)₃, [Os(CO)₃I₂]₂, [Os₃(CO)₁₂], OsH₄ (PPh₃)₃Cp₂Os, Cp*₂Os, H₂OsCl₆ x 6H₂O, OsCl₃ x H₂O, Ru(acac)₃, RuCl₂(cod), Ru(2-methylallyl)₂(cod), [(µ-Cl)Ir(η⁴-1,5-cod)]₂, [(µ-Cl)Ir(η²-coe)₂]₂, Ir(acac)₃, IrCl₃ x nH₂O, (tht)₃IrCl₃, Ir(η³-allyl)₃, Ir(η³-metallyl)₃, worin cod Cyclooctadien, coe Cycloocten, acac Acetylacetonat und tht Tetrahydrothiophen bedeuten. Die Metallkomplexe können gemäß dem Fachmann bekannten Verfahren hergestellt werden bzw. sind kommerziell erhältlich.

Im Anschluss an die vorstehend erwähnte Umsetzung des mit dem Ligandvorläufer umzusetzenden Metallkomplexes mit einem oder mehreren Ligandvorläufern wird der erhaltene erfindungsgemäße Metallkomplex im Allgemeinen nach dem Fachmann bekannten Verfahren aufgearbeitet und gegebenenfalls gereinigt. Üblicherweise erfolgen Aufarbeitung und Reinigung durch Extraktion, Säulenchromatographie und/oder Umkristallisation gemäß dem Fachmann bekannten Verfahren.

Die erfindungsgemäßen Metallkomplexe werden in organischen Leuchtdioden (OLEDs) verwendet. Sie eignen sich als Emittersubstanzen, da sie eine Emission (Elektrolumineszenz) im sichtbaren Bereich des elektromagnetischen Spektrums aufweisen. Mithilfe der erfindungsgemäßen Metallkomplexe als Emittersubstanzen ist es möglich, Verbindungen bereitzustellen, die Elektrolumineszenz insbesondere im blauen Bereich des elektromagnetischen Spektrums mit guter Effizienz zeigen. Dabei ist die Quantenausbeute hoch und insbesondere die Lebensdauer und die Stabilität der erfindungsgemäßen Metallkomplexe im Device hoch.

Des Weiteren sind die erfindungsgemäßen Metallkomplexe als Elektronen-, Excitonen- oder Lochblocker, Lochleiter, Elektronenleiter, Lochinjektionsschicht oder Matrixmaterial in OLEDs geeignet, in Abhängigkeit von den eingesetzten Liganden und dem eingesetzten Zentralmetall.

Organische Leuchtdioden (OLEDs) sind grundsätzlich aus mehreren Schichten aufgebaut:
1. Anode (1)
2. Löcher-transportierende Schicht (2)
3. Licht-emittierende Schicht (3)
4. Elektronen-transportierende Schicht (4)
5. Kathode (5)

Es ist jedoch auch möglich, dass die OLED nicht alle der genannten Schichten aufweist, zum Beispiel ist eine OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Die erfindungsgemäßen Metallkomplexe können in verschiedenen Schichten einer OLED eingesetzt werden. Ein weiterer Gegenstand der vorliegenden Erfindung ist daher eine OLED enthaltend mindestens einen erfindungsgemäßen Metallkomplex sowie die Verwendung mindestens eines erfindungsgemäßen Metallkomplexes in OLEDs. Die erfindungsgemäßen Metallkomplexe werden bevorzugt in der Licht-emittierenden Schicht, besonders bevorzugt als Emittermoleküle, eingesetzt. Ein weiterer Gegenstand der vorliegenden Erfindung ist daher eine Licht-emittierende Schicht enthaltend mindestens einen erfindungsgemäßen Metallkomplex als Matrixmaterial oder Emittermolekül, bevorzugt als Emittermolekül. Bevorzugte erfindungsgemäße Metallkomplexe sind vorstehend genannt.

Die erfindungsgemäßen Metallkomplexe können in Substanz - ohne weitere Zusätze - in der Licht-emittierenden Schicht oder einer anderen Schicht der OLED, bevorzugt in der Licht-emittierenden Schicht, vorliegen. Es ist jedoch ebenfalls möglich und bevorzugt, dass neben den erfindungsgemäßen Metallkomplexen weitere Verbindungen in den Schichten, bevorzugt in der Licht-emittierenden Schicht, vorliegen. Beispielsweise kann in der Licht-emittierenden Schicht ein fluoreszierender Farbstoff anwesend sein, um die Emissionsfarbe des als Emittermoleküls eingesetzten erfindungsgemäßen Metallkomplexes zu verändern. Des Weiteren kann - in einer bevorzugten Ausführungsform - mindestens ein Matrixmaterial eingesetzt werden. Geeignete Matrixmaterialien sind dem Fachmann bekannt. Im Allgemeinen wird das Matrixmaterial so ausgewählt, dass die Bandlücke des Matrixmaterials größer ist als die Bandlücke des als Emitter eingesetzten, erfindungsgemäßen Metallkomplexes. Unter Bandlücke ist im Sinne der vorliegenden Anmeldung die Triplettenergie zu verstehen. Bevorzugt eingesetzte geeignete Matrixmaterialien, insbesondere bei Verwendung von erfindungsgemäßen Metallkomplexen als Emittermaterialien, die im blauen Bereich des elektromagnetischen Spektrums Licht emittieren, sind z. B. Carbenkomplexe, insbesondere die in WO 2005/019373, WO 2005/0113704, WO 2006/018292, WO 2006/056418, WO 2007/115981, WO 2008/000726 und WO 2008/000727 genannten Carbenkomplexe; Disilylcarbazole, z. B. 9-(4-tert.-Butyl-phenyl)-3,6-bis(triphenylsilylcarbazol), 9-(Phenyl)-3,6-bis(triphenylsilyl)carbazol sowie in der nicht vorveröffentlichten PCT-Anmeldung mit dem Aktenzeichen PCT/EP 2007/059648 genannte Disilylcarbazole und die in WO 2004/095889, EP 1617710, EP 1617711, WO 2006/112265, WO 2006/130598 aufgeführten Verbindungen.

Die einzelnen der vorstehend genannten Schichten der OLED können wiederum aus 2 oder mehreren Schichten aufgebaut sein. Beispielsweise kann die Löcher-transportierende Schicht aus einer Schicht aufgebaut sein, in die aus der Elektrode Löcher injiziert werden und einer Schicht, die die Löcher von der Lochinjektionsschicht weg in die Licht-emittierende Schicht transportiert. Die Elektronen-transportierende Schicht kann ebenfalls aus mehreren Schichten bestehen, zum Beispiel einer Schicht, worin Elektronen durch die Elektrode injiziert werden, und einer Schicht, die aus der Elektroneninjektionsschicht Elektronen erhält und in die Licht-emittierende Schicht transportiert. Diese genannten Schichten werden jeweils nach Faktoren wie Energie-niveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäßen, bevorzugt als Emittersubstanzen verwendeten Metallkomplexe angepasst ist.

Um besonders effiziente OLEDs zu erhalten, sollte das HOMO (höchstes besetztes Molekülorbital) der Loch-transportierenden Schicht mit der Arbeitsfunktion der Anode angeglichen sein und das LUMO (niedrigstes unbesetztes Molekülorbital) der elektronentransportierenden Schicht sollte mit der Arbeitsfunktion der Kathode angeglichen sein.

Ein weiterer Gegenstand der vorliegenden Anmeldung ist eine OLED enthaltend mindestens eine erfindungsgemäße Licht-emittierende Schicht. Die weiteren Schichten in der OLED können aus einem beliebigen Material aufgebaut sein, das üblicherweise in solchen Schichten eingesetzt wird und dem Fachmann bekannt ist.

Geeignete Materialien für die vorstehend genannten Schichten (Anode, Kathode, Loch- und Elektroneninjektionsmaterialien, Loch- und Elektronentransportmaterialien und Loch- und Elektronenblockermaterialien, Matrixmaterialien, Fluoreszenz- und Phosphoreszenzemitter) sind dem Fachmann bekannt und z. B. in H. Meng, N. Herron, Organic Small Molecule Materials for Organic Light-Emitting Devices in Organic Light-Emitting Materials and Devices, Ed.: Z. Li, H. Meng, Taylor & Francis, 2007, Chapter 3, Seiten 295 bis 411 genannt.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen 11, 4, 5 und 6 des Periodensystems der Elemente sowie die Übergangsmetalle der Gruppen 8 bis 10. Wenn die Anode lichtdurchlässig sein soll, werden im Allgemeinen gemischte Metalloxide der Gruppen 12, 13 und 14 des Periodensystems der Elemente eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) der erfindungsgemäßen OLEDs sind zum Beispiel in Kirk-Othmer Encyclopedia of Chemical Technology, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl (a-NPD), N, N'-Diphenyl-N, N'-Bis(3-methylphenyl)-[1,1'-biphenyl]-4,4'-diamin (TPD), 1,1-Bis[(di-4-tolylamino)-phenyl]cyclohexan (TAPC), N, N'-Bis(4-methylphenyl)-N,N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzal-dehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-tetrakis(4-methylphenyl)-(1,1'-biphenyl)-4,4'-diamin (TTB) 4,4',4"-tris(N,N-Diphenylamino)triphenylamin (TDTA) und Porphyrinverbindungen sowie Phthalocyaninen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen, PEDOT (Poly(3,4-ethylendioxythiophen), bevorzugt PEDOT dotiert mit PSS (Polystyrolsulfonat), und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Geeignete Elektronentransportmaterialien für die Schicht (4) der erfindungsgemäßen OLEDs umfassen mit oxinoiden Verbindungen chelatisierte Metalle wie Tris(8-hydroxy-chinolato)aluminium (Alq₃), Verbindungen auf Phenanthrolinbasis wie 2,9-Dimethyl, 4,7-Diphenyl-1, 10-phenanthrolin (DDPA = BCP) oder 4,7-Diphenyl-1,10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Ex-citons an den Grenzflächen der Schichten des OLEDs zu vermeiden. Vorzugsweise verbessert die Schicht (4) die Beweglichkeit der Elektronen und reduziert ein Quenchen des Excitons.

Von den vorstehend als Lochtransportmaterialien und Elektronen transportierende Materialien genannten Materialien können einige mehrere Funktionen erfüllen. Zum Beispiel sind einige der Elektronen leitenden Materialien gleichzeitig Löcher blockende Materialien, wenn sie ein tief liegendes HOMO aufweisen.

Die Ladungstransportschichten können auch elektronisch dotiert sein, um die Transporteigenschaften der eingesetzten Materialien zu verbessern, um einerseits die Schichtdicken großzügiger zu gestalten (Vermeidung von Pinholes/Kurzschlüssen) und um andererseits die Betriebsspannung des Devices zu minimieren. Beispielsweise können die Lochtransportmaterialien mit Elektronenakzeptoren dotiert werden, zum Beispiel können Phthalocyanine bzw. Arylamine wie TPD oder TDTA mit Tetrafluorotetracyano-chinodimethan (F4-TCNQ) dotiert werden. Die Elektronentransportmaterialien können zum Beispiel mit Alkalimetallen dotiert werden, beispielsweise Alq₃ mit Lithium. Die elektronische Dotierung ist dem Fachmann bekannt und zum Beispiel in W. Gao, A. Kahn, J. Appl. Phys., Vol. 94, No. 1, 1 July 2003 (p-dotierte organische Schichten); A. G. Werner, F. Li, K. Harada, M. Pfeiffer, T. Fritz, K. Leo, Appl. Phys. Lett., Vol. 82, No. 25, 23 June 2003 und Pfeiffer et al., Organic Electronics 2003, 4, 89 - 103 offenbart.

Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe 1, zum Beispiel Li, Cs, Erdalkalimetallen der Gruppe 2, Metallen der Gruppe 12 des Periodensystems der Elemente, umfassend die Seltenerdmetalle und die Lanthanide und Aktinide. Des Weiteren können Metalle wie Aluminium, Indium, Calcium, Barium, Sama-rium und Magnesium sowie Kombinationen davon eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Die OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält die erfindungsgemäße OLED zusätzlich zu den Schichten (1) bis (5) mindestens eine der im Folgenden genannten weiteren Schichten:
- eine Loch-Injektionsschicht zwischen der Anode (1) und der Löcher-transportierenden Schicht (2);
- eine Blockschicht für Elektronen und/oder Excitonen zwischen der Löcher-transportierenden Schicht (2) und der Licht-emittierenden Schicht (3);
- eine Blockschicht für Löcher und/oder Excitonen zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Wie bereits vorstehend erwähnt, ist es jedoch auch möglich, dass die OLED nicht alle der genannten Schichten (1) bis (5) aufweist, zum Beispiel ist eine OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Dem Fachmann ist bekannt, wie er (zum Beispiel auf Basis von elektrochemischen Untersuchungen) geeignete Materialien auswählen muss. Geeignete Materialien für die einzelnen Schichten sowie geeignete OLED-Aufbauten sind dem Fachmann bekannt und z. B. in WO 2005/113704 offenbart.

Des Weiteren kann jede der genannten Schichten der erfindungsgemäßen OLED aus zwei oder mehreren Schichten aufgebaut sein. Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, eine OLED mit einer hohen Effizienz zu erhalten.

Die Herstellung der erfindungsgemäßen OLED kann nach dem Fachmann bekannten Methoden erfolgen. Im Allgemeinen wird die OLED durch aufeinanderfolgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden. Zusammensetzungen, die neben dem mindestens einen erfindungsgemäßen Metallkomplex ein polymeres Material in einer der Schichten der OLED, bevorzugt in der Licht-emittierenden Schicht, aufweisen, werden im Allgemeinen mittels lösungsverarbeitenden Verfahren als Schicht aufgebracht.

Im Allgemeinen haben die verschiedenen Schichten folgende Dicken: Anode (1) 500 bis 5000 Å, bevorzugt 1000 bis 2000 Å; Löcher-transportierende Schicht (2) 50 bis 1000 Å, bevorzugt 200 bis 800 Å, Licht-emittierende Schicht (3) 10 bis 1000 Å, bevorzugt 100 bis 800 Å, Elektronen transportierende Schicht (4) 50 bis 1000 Å, bevorzugt 200 bis 800 Å, Kathode (5) 200 bis 10.000 Å, bevorzugt 300 bis 5000 Ä. Die Lage der Rekombinationszone von Löchern und Elektronen in der erfindungsgemäßen OLED und somit das Emissionsspektrum der OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in der OLED ist von den eingesetzten Materialien abhängig. Die Schichtdicken von gegebenenfalls eingesetzten zusätzlichen Schichten sind dem Fachmann bekannt.

Durch Einsatz der erfindungsgemäßen Metallkomplexe in mindestens einer Schicht der erfindungsgemäßen OLED, bevorzugt als Emittermolekül in der Licht-emittierenden Schicht der erfindungsgemäßen OLEDs, können OLEDs mit hoher Effizienz erhalten werden. Die Effizienz der erfindungsgemäßen OLEDs kann des Weiteren durch Optimierung der anderen Schichten verbessert werden. Beispielsweise können hoch effiziente Kathoden wie Ca, Ba oder LiF eingesetzt werden. Geformte Substrate und neue Löcher-transportierende Materialien, die eine Reduktion der Operationsspannung oder eine Erhöhung der Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen. Stationäre Bildschirme sind z. B. Bildschirme von Computern, Fernsehern, Bildschirme in Druckern, Küchengeräten sowie Reklametafeln, Beleuchtungen und Hinweistafeln. Mobile Bildschirme sind z. B. Bildschirme in Handys, Laptops, Kameras, insbesondere Digitalkameras, Fahrzeugen sowie Zielanzeigen an Bussen und Bahnen.

Weiterhin können die erfindungsgemäßen Metallkomplexe in OLEDs mit inverser Struktur eingesetzt werden. Bevorzugt werden die erfindungsgemäßen Metallkomplexe in diesen inversen OLEDs wiederum in der Licht-emittierenden Schicht eingesetzt. Der Aufbau von inversen OLEDs und die üblicherweise darin eingesetzten Materialien sind dem Fachmann bekannt.

## Patentansprüche

1. Metallkomplex enthaltend mindestens einen Liganden der allgemeinen Formel (I) 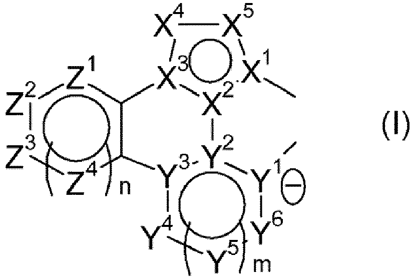 worin die Symbole die folgenden Bedeutungen aufweisen:
Y⁵, Z⁴ unabhängig voneinander CD, CR¹, CH, N;
X¹ N;
X², X³, Y¹, Y², Y³ unabhängig voneinander N oder C;
X⁵ CD;
X⁴ CD oder CR¹;
Y⁴, Y⁶ unabhängig voneinander CD, CR¹, CH, N; wobei Y⁴ oder Y⁶ im Falle von m = 0 des Weiteren S, O oder NR¹ bedeuten können;
Z¹, Z², Z³ unabhängig voneinander CD, CR¹, CH, N; wobei Z¹, Z² oder Z³ im Falle von n = 0 des Weiteren S, O oder NR¹ bedeuten können;
R¹ unabhängig voneinander unsubstituiertes oder substituiertes Alkyl, unsubstituiertes oder substituiertes Cycloalkyl, unsubstituiertes oder substituiertes Heterocycloalkyl, unsubstituiertes oder substituiertes Aryl, unsubstituiertes oder substituiertes Heteroaryl, unsubstituiertes oder substituiertes Alkenyl, unsubstituiertes oder substituiertes Cycloalkenyl, unsubstituiertes oder substituiertes Alkinyl, SiR²₃, Halogen, ein Substituent mit Donor- oder Akzeptorwirkung, wobei in dem Fall, wenn R¹ an ein N-Atom gebunden ist, R¹ unabhängig voneinander unsubstituiertes oder substituiertes Alkyl oder unsubstituiertes oder substituiertes Aryl oder unsubstituiertes oder substituiertes Heteroaryl bedeutet, wobei zwei beliebige Reste R¹ des Weiteren gemeinsam eine Alkylen- oder Arylenbrücke bilden können;
R² unabhängig voneinander unsubstituiertes oder substituiertes Alkyl oder unsubstituiertes oder substituiertes Aryl oder unsubstituiertes oder substituiertes Heteroaryl;
m, n unabhängig voneinander 0 oder 1, wobei die Gruppen Z⁴ bzw. Y⁵ bei n bzw. m = 0 nicht vorhanden sind.

2. Metallkomplex nach Anspruch 1, **dadurch gekennzeichnet, dass** X², X³, Y¹, Y², Y³, Y⁴, Y⁵, Y⁶, Z¹, Z², Z³, Z⁴ unabhängig voneinander die folgenden Bedeutungen aufweisen:
X², Y¹, Y², Y³ C;
X3 C oder N, bevorzugt N;
Y⁴, Y⁵, Y⁶ unabhängig voneinander CH, CD oder CR¹, bevorzugt CD;
Z¹, Z², Z³, Z⁴ unabhängig voneinander CH, CD, CR¹ oder N, wobei Z¹, Z² oder Z³ im Falle von n = 0 des Weiteren S, O oder NR¹ bedeuten können, bevorzugt bedeuten Z¹, Z² und Z⁴ CD und Z³ CR¹.

3. Metallkomplex nach Anspruch 1 oder 2, **dadurch gekennzeichnet, dass**
X³ N; und
Y⁴, Y⁵, Y⁶, Z¹, Z² und Z⁴
CD;
X⁴, Z³
CR¹
bedeuten.

4. Metallkomplex nach einem der Ansprüche 1 bis 3, **dadurch gekennzeichnet, dass**
m 1 bedeutet.

5. Metallkomplex nach einem der Ansprüche 1 bis 4, **dadurch gekennzeichnet, dass** der Metallkomplex die allgemeine Formel (II) aufweist 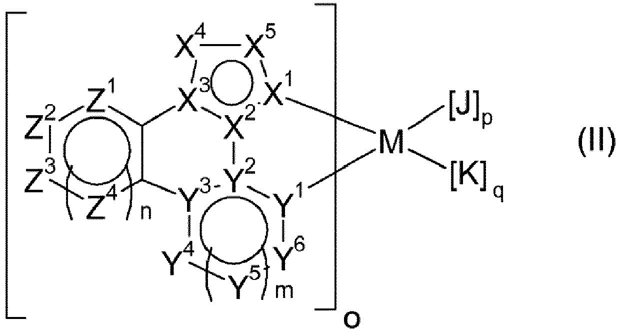 worin bedeuten:
M Metallatom ausgewählt aus der Gruppe bestehend aus Übergangsmetallen der Gruppe IB, IIB, IIIB, IVB, VB, VIB, VIIB, VIII des Periodensystems der Elemente (CAS-Version), in jeder für das entsprechende Metallatom möglichen Oxidationsstufe; bevorzugt Ir(III), Pt(II) oder Os(II), besonders bevorzugt Ir(III);
J mono- oder dianionischer Ligand, der monooder bidentat sein kann, bevorzugt bidentater, monoanionischer Ligand;
K neutraler, monooder bidentater Ligand, der im Allgemeinen nicht photoaktiv ist: bevorzugte Liganden K sind Phosphine, insbesondere Trialkylphosphine, z. B. PEt₃, PnBu₃, Triarylphosphine, z. B. PPh₃; Phosphonate und Derivate davon, Arsenate und Derivate davon, Phosphite, CO, Nitrile, Amine, Diene, die einen π-Komplex mit M bilden können, z. B. 2,4- Hexadien, η⁴-Cyclooctadien und η²-Cyclooctadien (jeweils 1,3 und 1,5), Allyl, Methallyl, Cycloocten, Norbornadien und neutrale Biscarbene;
o 1, 2, 3 oder 4; wobei o für M = Ir(III) 1, 2 oder 3, bevorzugt 2 oder 3; für M = Pt(II) oder Os(II) 1 oder 2; bedeutet;
p 0, 1 , 2, 3 oder 4; wobei p für M = Ir(III) 0, 1, 2, 3 oder 4, bevorzugt 0 oder 2; für M = Pt(II) und Os(II) 0, 1 oder 2, bevorzugt 0 oder 2; bedeutet, wobei p die Zahl der Bindungsstellen zum Metall M bedeutet, d.h., wenn p = 2 ist, kann es sich um zwei monodentate oder einen bidentaten Liganden handeln;
q 0, 1, 2, 3 oder 4; wobei q für M = Ir(III) 0, 1 oder 2, bevorzugt 0; für M = Pt(II) 0 oder 1, bevorzugt 0; für Os(II) 2 oder 3, bevorzugt 2 bedeutet, wobei q die Zahl der Bindungsstellen zum Metall M bedeutet, d.h., wenn q = 2 ist, kann es sich um zwei monodentate oder einen bidentaten Liganden handeln;
wobei o, p und q von der Oxidationsstufe und Koordinationszahl des eingesetzten Metallatoms und der Ladung der Liganden abhängig sind.

6. Metallkomplex nach Anspruch 5, **dadurch gekennzeichnet, dass** der Metallkomplex die allgemeine Formel (IIa) aufweist 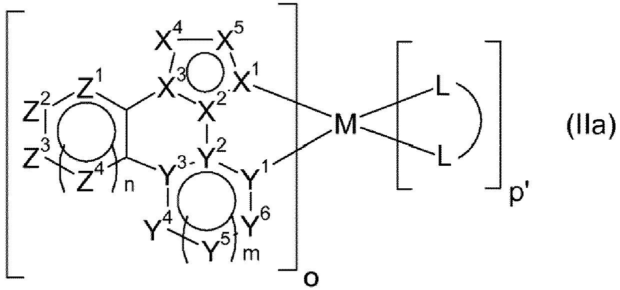 worin bedeuten:
M Metallatom ausgewählt aus der Gruppe bestehend aus Übergangsmetallen der Gruppe IB, IIB, IIIB, IVB, VB, VIB, VIIB, VIII des Periodensystems der Elemente (CAS-Version), in jeder für das entsprechende Metallatom möglichen Oxidationsstufe; bevorzugt Ir(III), Pt(II), besonders bevorzugt Ir(III); 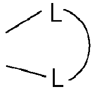 bidentater monoanionischer Ligand, der einen oder mehrere Deuteriumatome aufweisen kann;
o 1, 2, 3, 4; wobei o für M = Ir(III) 1, 2 oder 3, bevorzugt 2 oder 3; für M = Pt(II) 1 oder 2; bedeutet;
p' 0, 1 oder 2; wobei p für M = Ir(III) 0, 1 oder 2, bevorzugt 0 oder 1; für M = Pt(II) 0 oder 1; bedeutet, wobei p' die Zahl der Liganden 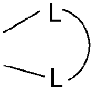 bedeutet;
wobei o und p' von der Oxidationsstufe und Koordinationszahl des eingesetzten Metallatoms abhängig sind.

7. Metallkomplex nach Anspruch 6, **dadurch gekennzeichnet, dass** L in dem bidentaten monoanionischen Liganden jeweils unabhängig voneinander ausgewählt ist aus O, N und C; bevorzugt sind monoanionische bidentate Liganden, worin beide Gruppen L O, C oder N bedeuten oder eine Gruppe L O bedeutet und die andere Gruppe L N oder C bedeutet oder eine Gruppe L C bedeutet und die andere Gruppe L N bedeutet; besonders bevorzugt sind die bidentaten monoanionischen Liganden ausgewählt aus der Gruppe bestehend aus Acetylacetonat, Picolinat, Carbenen, Arylpyridinen und Arylimidazolen und Derivaten der vorstehend genannten Verbindungen.

8. Metallkomplex nach Anspruch 6 oder 7, **dadurch gekennzeichnet, dass** der Metallkomplex die allgemeine Formel (IIaa) aufweist 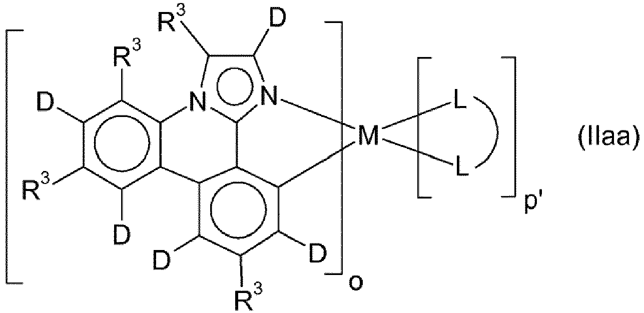 worin
D Deuterium, und
R³ unabhängig voneinander Deuterium oder R¹ bedeutet.

9. Metallkomplex nach einem der Ansprüche 6 bis 8, worin bedeuten:
M Ir(III), Pt(II), bevorzugt Ir(III);
o für M = Ir(III), 1, 2 oder 3, bevorzugt 2 oder 3; für M = Pt(II) 1 oder 2;
p' für M = Ir(III), 0, 1 oder 2, bevorzugt 0 oder 1; für M = Pt(II) 0 oder 1;
wobei die Summe o + p' für M = Ir(III) 3 und für M = Pt(II) 2 bedeutet und o mindestens 1 ist.

10. Organische Leuchtdiode enthaltend mindestens einen Metallkomplex gemäß einem der Ansprüche 1 bis 9.

11. Licht-emittierende Schicht enthaltend mindestens einen Metallkomplex gemäß einem der Ansprüche 1 bis 9.

12. Organische Leuchtdiode enthaltend mindestens eine Licht-emittierende Schicht gemäß Anspruch 11.

13. Verwendung von mindestens einem Metallkomplex gemäß einem der Ansprüche 1 bis 9 in organischen Leuchtdioden.

14. Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Digitalkameras, Fahrzeugen sowie Zielanzeigen an Bussen und Bahnen enthaltend mindestens eine organische Leuchtdiode gemäß Anspruch 10 oder 12.

## Claims

1. Metal complex comprising at least one ligand having the general formula (I) 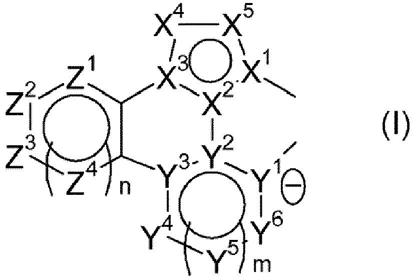 wherein the symbols have the following meanings:
Y⁵, Z⁴ independently from each other CD, CR¹, CH, N;
X¹ N;
X², X³, Y¹, Y², Y³ independently from each other N or C;
X⁵ CD;
X4 CD or CR¹;
Y⁴, Y⁶ independently from each other CD, CR¹, CH, N; wherein Y⁴ or Y⁶ in case of m = 0 further can mean S, O or NR¹;
Z¹, Z², Z³ independently from each other CD, CR¹, CH, N; wherein Z¹, Z² or Z³ in case of n = 0 further can mean S, O or NR¹;
R¹ independently from each other unsubstituted or substituted alkyl, unsubstituted or substituted cycloalkyl, unsubstituted or substituted heterocycloalkyl, unsubstituted or substituted aryl, unsubstituted or substituted heteroaryl, unsubstituted or substituted alkenyl, unsubstituted or substituted cycloalkenyl, unsubstituted or substituted alkinyl, SiR²₃, halogen, a substituent with donor or acceptor effect, wherein in the case that R¹ is bound to an N atom, R¹ independently from each other means unsubstituted or substituted alkyl or unsubstituted or substituted aryl or unsubstituted or substituted heteroaryl, wherein two arbitrary substituents R¹ can further together form an alkylene or arylene bridge;
R² independently from each other unsubstituted or substituted alkyl or unsubstituted or substituted aryl or unsubstituted or substituted heteroaryl;
m, n independently from each other 0 or 1, wherein the groups Z⁴ resp. Y⁵ are absent for n resp. m = 0.

2. Metal complex according to claim 1, **characterized in that** X², X³, Y¹, Y², Y³, Y⁴, Y⁵, Y⁶, Z¹, Z², Z³, Z⁴ independently from each other have the following meanings:
X², Y¹, Y², Y³ C;
X³ C or N, preferably N;
Y⁴, Y⁵, Y⁶ independently from each other CH, CD or CR¹, preferably CD;
Z¹, Z², Z³, Z⁴ independently from each other CH, CD, CR¹ or N, wherein Z¹, Z² or Z³ in case of n = 0 further can mean S, O or NR¹, preferably Z¹, Z² and Z⁴ mean CD and Z³ means CR¹.

3. Metal complex according to claim 1 or 2, **characterized in that** the symbols have the following meanings:
X³ N; and
Y⁴, Y⁵, Y⁶, Z¹, Z² and Z⁴
CD;
X⁴, Z³
CR¹.

4. Metal complex according to one of claims 1 to 3, **characterized in that**
m means 1.

5. Metal complex according to one of claims 1 to 4, **characterized in that** the metal complex has the general formula (II) 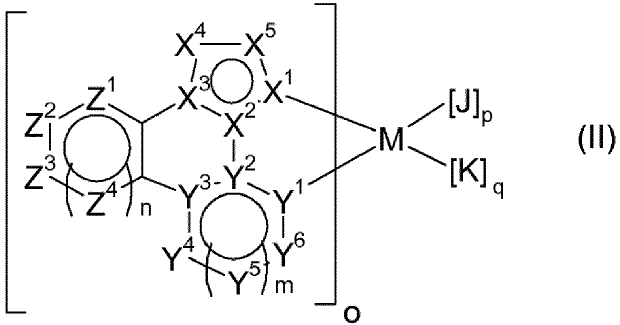 wherein the symbols have the following meanings:
M metal atom selected from the group consisting of transition metals of the group IB, IIB, IIIB, IVB, VB, VIB, VIIB, VIII of the periodic system of the elements (CAS version), in each oxidation stage possible for the respective metal atom; preferably Ir(III), Pt(II) or Os(II), especially preferably Ir(III);
J mono- or dianionic ligand which can be mono- or bidentate, preferably a bidentate, monoanionic ligand;
K neutral, mono- or bidentate ligand, which generally is not photoactive: preferred ligands K are phosphines, in particular trialkylphosphines, e.g. PEt₃, PnBu₃, triarylphosphines, e.g. PPh₃; phosphonates and derivatives thereof, arsenates and derivatives thereof, phosphites, CO, nitriles, amines, dienes which can form a π-complex with M, e.g. 2,4-hexadiene, η⁴-cyclooctadiene and η²-cyclooctadiene (each 1,3 and 1,5), allyl, methallyl, cyclooctene, norbornadiene and neutral biscarbenes;
o 1, 2, 3 or 4; wherein o for M = Ir(IIII) is 1, 2 or 3, preferably 2 or 3; for M = Pt(II) or Os(II) is 1 or 2;
p 0, 1 , 2, 3 or 4; wherein p for M = Ir(III) is 0, 1, 2, 3 or 4, preferably 0 or 2; for M = Pt(II) and Os(II) is 0, 1 or 2, preferably 0 or 2; wherein p is the number of binding sites with the metal M, i.e., when p = 2, there can be two monodentate or one bidentate ligands;
q 0, 1, 2, 3 or 4; wherein q for M = Ir(III) is 0, 1 or 2, preferably 0; for M = Pt(II) is 0 or 1, preferably 0; for Os(II) is 2 or 3, preferably 2, wherein q is the number of binding sites with the metal M, i.e., if q = 2, there can be two monodentate or one bidentate ligands;
wherein o, p and q are dependent on the oxidation stage and coordination number of the metal atom which is used, and on the charge of the ligands.

6. Metal complex according to claim 5, **characterized in that** the metal complex has the general formula (IIa) 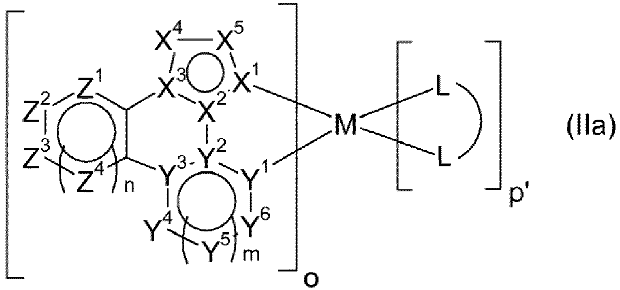 wherein the symbols have the following meanings:
M metal atom selected from the group consisting of transition metals of group IB, IIB, IIIB, IVB, VB, VIB, VIIB, VIII of the periodic system of the elements (CAS version), in each oxidation stage possible for the respective metal atom; preferably Ir(III), Pt(II), especially preferably Ir(III); 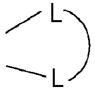 bidentate monoanionic ligand which may have one or more deuterium atoms;
o 1, 2, 3, 4; wherein o for M = Ir(III) is 1, 2 or 3, preferably 2 or 3; for M = Pt(II) is 1 or 2;
p' 0, 1 or 2; wherein p for M = Ir(III) is 0, 1 or 2, preferably 0 or 1; for M = Pt(II) is 0 or 1; wherein p' is the number of ligands 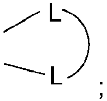
wherein o and p' are dependent on the oxidation stage and coordination number of the metal atom which is used.

7. Metal complex according to claim 6, **characterized in that** each L in the bidentate monoanionic ligand is selected independently from each other from O, N and C; monoanionic bidentate ligands are preferred wherein both groups L mean O, C or N, or one group L means O and the other group L means N or C, or one group L means C and the other group L means N; especially preferred are the bidentate monoanionic ligands selected from the group consisting of acetyl acetonate, picolinate, carbenenes, arylpyridines and arylimidazoles and derivatives of the compounds listed hereinbefore.

8. Metal complex according to claim 6 or 7, **characterized in that** the metal complex has the general formula (IIaa) 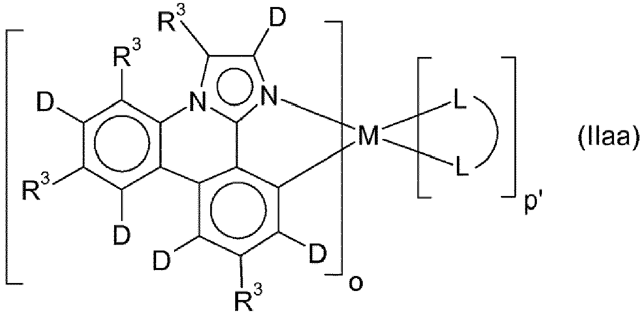 wherein
D means deuterium, and
R³ independently from each other means deuterium or R¹.

9. Metal complex according to one of claims 6 to 8, wherein the symbols have the following meanings:
M Ir(III), Pt(II), preferably Ir(III);
o for M = Ir(III), 1, 2 or 3, preferably 2 or 3; for M = Pt(II) 1 or 2;
p' for M = Ir(III), 0, 1 or 2, preferably 0 or 1; for M = Pt(II) 0 or 1;
wherein the sum o + p' for M = Ir(III) is 3 and for M = Pt(II) is 2, and o is at least 1.

10. Organic light-emitting diode comprising at least one metal complex according to one of the claims 1 to 9.

11. Light emitting layer comprising at least one metal complex according to one of the claims 1 to 9.

12. Organic light-emitting diode comprising at least one light emitting layer according to claim 11.

13. Use of at least one metal complex according to one of the claims 1 to 9 in organic light-emitting diodes.

14. Device selected from the group consisting of stationary visual display unit like computer monitors, televisions, visual display units in printers, kitchen appliances and advertising panels, illuminations, information panels and mobile visual display units like monitors of mobile phones, laptops, digital cameras, vehicles and destination displays on buses and trains comprising at least one organic light-emitting diode according to claim 10 or 12.

## Revendications

1. Complexe métallique contenant au moins un ligand ayant la formule générale (I) : 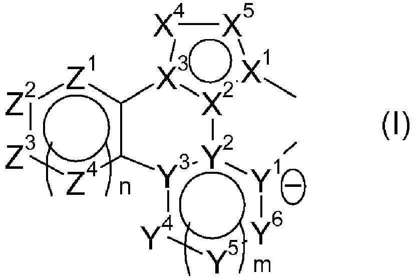 dans laquelle les symboles ont les significations suivantes :
Y⁵, Z⁴ **représentent indépendamment l'un de l'autre** CD, CR¹, CH, N,
X¹ représente N,
X², X³, Y¹, Y², Y³ représentent, indépendamment les uns des autres, N ou C,
X⁵ représente CD,
X⁴ représente CD ou CR¹,
Y⁴, Y⁶ représentent, indépendamment les uns des autres, CD, CR¹, CH, N, où Y⁴ ou Y⁶, dans le cas où m = 0, peuvent en outre représenter S, O ou NR¹,
Z¹, Z², Z³ représentent, indépendamment les uns des autres, CD, CR¹, CH, N, où Z¹, Z² ou Z³, dans le cas où n = 0, peuvent en outre représenter S, O ou NR¹,
R¹ représente indépendamment un alkyle non substitué ou substitué, un cycloalkyle non substitué ou substitué, un hétérocycloalkyle non substitué ou substitué, un aryle non substitué ou substitué, un hétéroaryle non substitué ou substitué, un alcényle non substitué ou substitué, un cycloalcényle non substitué ou substitué, un alcynyle non substitué ou substitué, SiR²₃, un halogène, un substituant à effet donneur ou accepteur, où, dans le cas où R¹ est lié à un atome N, R¹ représente indépendamment un alkyle non substitué ou substitué, ou un aryle non substitué ou substitué, ou un hétéroaryle non substitué ou substitué, dans laquelle deux résidus quelconques R¹ peuvent en outre former ensemble un pont alkyle ou aryle,
R² représente indépendamment un alkyle non substitué ou substitué, ou un aryle non substitué ou substitué, ou un hétéroaryle non substitué ou substitué,
m, n représentent, **indépendamment l'un de l'autre**, 0 ou 1, les groupes Z⁴, respectivement Y⁵, étant absents lorsque n = 0, respectivement m = 0.

2. Complexe métallique selon la revendication 1, **caractérisé en ce que** X², X³, Y¹, Y², Y³, Y⁴, Y⁵, Y⁶, Z¹, Z², Z³, Z⁴ ont, indépendamment les uns des autres, les significations suivantes :
X², Y¹, Y², Y³ représentent C,
X³ représente C ou N, de préférence N,
Y⁴, Y⁵, Y⁶ représentent, indépendamment les uns des autres, CH, CD ou CR¹, de préférence CD,
Z¹, Z², Z³, Z⁴ représentent, indépendamment les uns des autres, CH, CD, CR¹ ou N, dans laquelle Z¹, Z² ou Z³, dans le cas où n = 0, peuvent en outre représenter S, O ou NR¹, Z¹, Z² et Z⁴ représentant de préférence CD et Z³ CR¹.

3. Complexe métallique selon la revendication 1 ou 2, **caractérisé en ce que**
X³ représente N, et
Y⁴, Y⁵, Y⁶, Z¹, Z² et Z⁴
représentent CD,
X⁴, Z³
représentent CR¹.

4. **Complexe métallique selon l'une des revendications** 1 à 3, caractérisé e ce que
m est égal à 1.

5. **Complexe métallique selon l'une des revendications** 1 à 4, **caractérisé en ce que** le complexe métallique a la formule générale (II) : 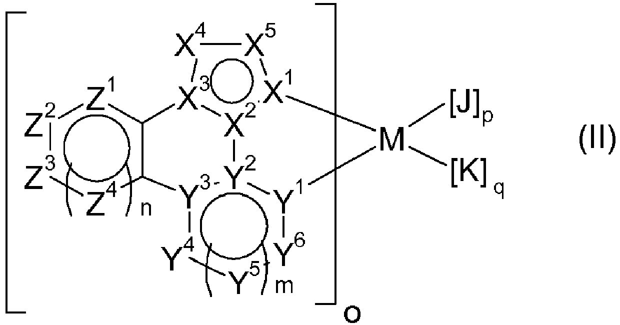 dans laquelle :
M représente un atome métallique choisi parmi le groupe constitué de métaux de transition des groupes IB, IIB, IIIB, IVB, VB, VIB, VIIB, VIII du tableau périodique des éléments (version CAS), dans chaque état **d'oxydation possible pour l'atome métallique correspondant,** de préférence Ir(III), Pt(II) ou Os(II), de manière particulièrement préférée Ir(III),
J représente un ligand mono- ou di-anionique qui peut être mono- ou bidenté, de préférence un ligand monoanionique bidenté,
K représente un ligand mono- ou bidenté, neutre, qui n'est généralement pas photoactif : les ligands K sont de préférence une phosphine, en particulier une trialkylphosphine, par exemple PEt₃, PnBu₃, un triarylphosphine, par exemple PPh₃, un phosphonate et un dérivé de celui-ci, un arsenate et un dérivé de celui-ci, un phosphite, CO, un nitrile, une amine, un diène, qui peuvent former un complexe π avec M, par exemple 2,4- hexadiène, η⁴-cyclooctadiène et η²-cyclooctadiène (respectivement 1,3 et 1,5), un allyle, un méthallyle, un cyclooctène, un norbornadiène et un biscarbène neutre,
o est égal à 1, 2, 3 ou 4, où pour M = Ir(III), o est égal à 1, 2 ou 3, de préférence à 2 ou 3, et pour M = Pt(II) ou Os(II), o est égal à 1 ou 2,
p est égal à 0, 1 , 2, 3 ou 4, où pour M = Ir(III), p est égal à 0, 1, 2, 3 ou 4, de préférence à 0 ou 2, pour M = Pt(II) et Os(II), p est égal à 0, 1 ou 2, de préférence à 0 ou 2, p représentant le nombre de sites de liaison avec le métal M, c'est-à-dire que lorsque p = 2, les ligands peuvent être deux ligands monodentés ou un ligand bidenté,
q est égal à 0, 1, 2, 3 ou 4, où pour M = Ir(III), q est égal à 0, 1 ou 2, de préférence à 0, pour M = Pt(II), q est égal à 0 ou 1, de préférence à 0, pour Os(II), q est égal à 2 ou 3, de préférence à 2, q représentant le nombre de sites de liaison avec le métal M, c'est-à-dire que lorsque q = 2, les ligands peuvent être deux ligands monodentés ou un ligand bidenté,
dans laquelle o, p et q **dépendent de l'état d'oxydation et de l'indice de coordination de l'atome métallique présent et de la charge des** ligands.

6. Complexe métallique selon la revendication 5, **caractérisé en ce que** le complexe métallique a la formule générale (IIa) : 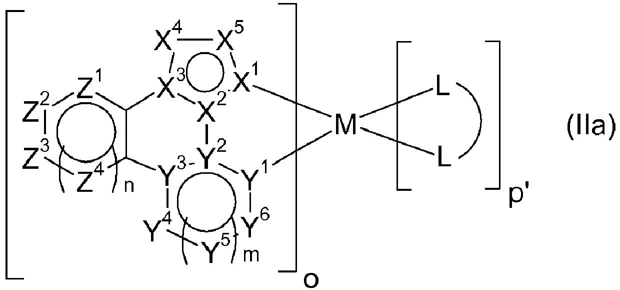 dans laquelle :
M représente un atome métallique choisi parmi le groupe constitué des métaux de transition des groupes IB, IIB, IIIB, IVB, VB, VIB, VIIB, VIII du tableau périodique des éléments (version CAS), dans chaque état **d'oxydation possible pour l'atome métallique correspondant,** de préférence Ir(III), Pt(II), de manière particulièrement préférée Ir(III), 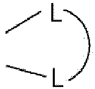 représente un ligand monoanionique bidenté qui peut comporter un ou plusieurs atomes de deutérium,
o est égal à 1, 2, 3, 4, où pour M = Ir(III), o est égal à 1, 2 ou 3, de préférence à 2 ou 3, pour M = Pt(II), o est égal à 1 ou 2,
p' est égal à 0, 1 ou 2, où pour M = Ir(III), p' est égal à 0, 1 ou 2, de préférence à 0 ou 1, pour M = Pt(II), p' est égal à 0 ou 1, p' représentant le nombre de ligands 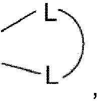 dans laquelle o et p' **dépendent de l'état d'oxydation et de l'indice de coordination de l'atome métallique présent.**

7. Complexe métallique selon la revendication 6, **caractérisé en ce que** L dans le ligand monoanionique bidenté est respectivement choisi indépendamment parmi O, N et C, les ligands étant de préférence des ligands monoanioniques bidentés, où les deux groupes représentent L O, C, ou N ou un groupe représente L O et **l'autre groupe représente** L N ou C, ou un groupe représente L C **et l'autre groupe représente** L N, les ligands monoanioniques bidentés étant de manière particulièrement préférée **choisis parmi le groupe constitué d'acé**tylacétonate, de picolinate, de carbènes, **d'a**rylpyridin**es et d'ar**ylimidazoles et de dérivés des composés précités.

8. Complexe métallique selon la revendication 6 ou 7, **caractérisé en ce que** le complexe métallique a la formule générale (IIaa) : 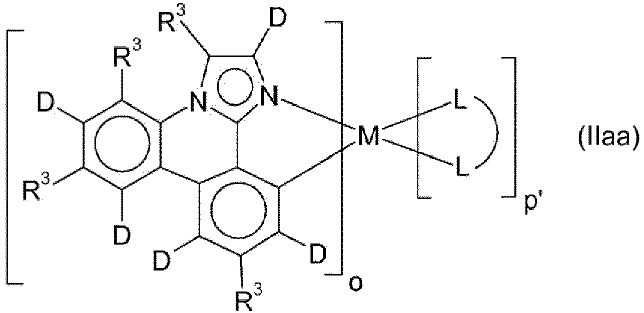 dans laquelle
D représente le deutérium, et
R³ représente indépendamment le deutérium ou R¹.

9. **Complexe métallique selon l'une des revendications** 6 à 8, dans lequel :
M représente Ir(III), Pt(II), de préférence Ir(III),
o est égal à 1, 2 ou 3, de préférence à 2 ou 3, pour M = Ir(III), o est égal à 1 ou 2 pour M = Pt(II),
p' est égal à 0, 1 ou 2, de préférence à 0 ou 1, pour M = Ir(III), p' est égal à 0 ou 1 pour M = Pt(II),
dans lequel la somme o + p' est égale à 3 pour M = Ir(III) et à 2 pour M = Pt(II), et o est au moins égal à 1.

10. Diode électroluminescente organique contenant au moins un complexe **métallique selon l'une des revendications 1** à 9.

11. Couche électroluminescente contenant au moins un complexe métallique **selon l'une des** revendications 1 à 9.

12. Diode électroluminescente organique contenant au moins une couche électroluminescente selon la revendication 11.

13. **Utilisation d'au moins un complexe métallique selon l'une des** revendications 1 à 9 dans des diodes électroluminescentes organiques.

14. **Dispositif choisi parmi le groupe constitué d'écrans** fixes tels que des **écrans d'ordinateurs,** des téléviseurs, **des écrans d'imprimantes,** des appareils de cuisine ainsi que des panneaux publicitaires, des éclairages, des panneaux **d'information,** et d'écrans mobiles tels que des écrans de téléphones portables, **d'ordinateurs portables,** de caméras numériques, de véhicules ainsi que des affichages de destination dans les bus et sur les voies, contenant au moins une diode électroluminescente organique selon la revendication 10 ou 12.
